(19) Europäisches Patentamt
European Patent Office
Office européen des brevets

(11) EP 4 723 114 A1

(12) **EUROPEAN PATENT APPLICATION**

(43) Date of publication:
08.04.2026 Bulletin 2026/15

(21) Application number: 25174483.5

(22) Date of filing: 06.05.2025

(51) International Patent Classification (IPC):
G11C 5/14 (2006.01)      G11C 11/56 (2006.01)
G11C 16/22 (2006.01)     G11C 16/04 (2006.01)

(52) Cooperative Patent Classification (CPC):
G11C 11/5628; G11C 5/148; G11C 16/225;
G11C 16/0483

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 07.10.2024 KR 20240136104
03.04.2025 US 202519169276

(71) Applicant: Samsung Electronics Co., Ltd.
Suwon-si, Gyeonggi-do 16677 (KR)

(72) Inventors:
• OH, Eun Chu
16677 Suwon-si, Gyeonggi-do (KR)
• DOH, In Hwan
16677 Suwon-si, Gyeonggi-do (KR)
• LEE, Changon
16677 Suwon-si, Gyeonggi-do (KR)
• CHOI, Wan-Soo
16677 Suwon-si, Gyeonggi-do (KR)

(74) Representative: Kuhnen & Wacker
Patent- und Rechtsanwaltsbüro PartG mbB
Prinz-Ludwig-Straße 40A
85354 Freising (DE)

(54) **STORAGE DEVICE CONFIGURED TO WRITE DATA BASED ON WRITE ENERGY AND METHOD OF OPERATING THE SAME**

(57) A storage device is provided. The storage device includes: a nonvolatile memory device including a memory cell array, the memory cell array having a user area and a power loss protection (PLP) area; and a storage controller configured to, based on sudden power-off being detected, write first PLP data in a first memory cell connected to a first word line of the PLP area and write second PLP data in a second memory cell connected to a second word line of the PLP area. A first write energy of the first memory cell is less than a second write energy of the second memory cell.

FIG. 1

**Description**

CROSS-REFERENCE TO RELATED APPLICATION

This application claims priority to Korean Patent Application No. 10-2024-0136104, filed on October 7, 2024, in the Korean Intellectual Property Office, disclosure disclosures of which is incorporated by reference herein in its entirety.

BACKGROUND

The present disclosure relates to a storage device, and more particularly, to a storage device efficiently storing data in response to sudden power-off.

A semiconductor memory is classified as a volatile memory device, which loses data stored therein when a power is turned off, such as a static random access memory (SRAM) or a dynamic RAM (DRAM), or a non-volatile memory device, which retains data stored therein even when a power is turned off, such as a flash memory, a phase-change RAM (PRAM), a magnetic RAM (MRAM), a resistive RAM (RRAM), or a ferroelectric RAM (FRAM).

A storage device such as a solid state drive (SSD) may include a nonvolatile memory device, such as a flash memory, to store data semi-permanently and may also include a volatile memory device, such as a DRAM, to temporarily store data read from the nonvolatile memory device or data to be written in the nonvolatile memory device. In addition, a super capacitor present in the SSD may be used as a power source to store power loss protection (PLP) data being processed in the DRAM in the power-off of the SSD.

However, according to a high-capacity storage device such as an SSD, the amount of data to be urgently stored in the SSD when the sudden power-off occurs is increasing, and a way to efficiently use a limited power of the super capacitor is also becoming important.

SUMMARY

One or more embodiments provide a method of efficiently writing power loss protection (PLP) data being processed, based on write energy, when sudden power-off occurs.

One or more embodiments provide a method of efficiently writing user data based on write energy.

According to an aspect of an embodiment, a storage device includes: a nonvolatile memory device including a memory cell array, the memory cell array having a user area and a PLP area; and a storage controller configured to, based on sudden power-off being detected, write first PLP data in a first memory cell connected to a first word line of the PLP area and write second PLP data in a second memory cell connected to a second word line of the PLP area. A first write energy of the first memory cell is less than a second write energy of the second memory cell.

According to another aspect of an embodiment, a storage device includes: a nonvolatile memory device including a memory cell array, the memory cell array including a user area and a PLP area; and a storage controller configured to, based on sudden power-off being detected, write first PLP data in a first memory cell connected to a first word line, write dummy data in a second memory cell connected to a second word line of the PLP area, and write second PLP data in a third memory cell connected to a third word line of the PLP area, which is adjacent to the second word line, and having second write energy. The second word line is adjacent each of the first word line and the third word line. A first write energy of the first memory cell is less than a second write energy of the second memory cell.

According to another aspect of an embodiment, a storage device includes: a nonvolatile memory device including a memory cell array, the memory cell array including a plurality of cell strings extending along a direction perpendicular to a substrate, wherein each of the plurality of cell strings includes at least one string selection transistor, a plurality of memory cells connected in series, and at least one ground selection transistor; and a storage controller configured to write first user data in a first memory cell from among the plurality of memory cells and write second user data in a second memory cell from among the plurality of memory cells. A first write energy of the first memory cell is less than a second write energy of the second memory cell.

BRIEF DESCRIPTION OF DRAWINGS

The above and other objects and features will be more apparent from the following description of embodiments, taken in conjunction with the accompanying drawings, in which:

FIG. 1 is a block diagram of a storage system according to an embodiment.
FIG. 2 illustrates a configuration of a storage controller according to an embodiment.
FIG. 3 is a block diagram illustrating a nonvolatile memory device according to an embodiment.
FIG. 4 illustrates an example of a memory block according to an embodiment.

FIG. 5 is a cross-sectional view illustrating an example of a cell strings of a memory block according to an embodiment.

FIG. 6 is a flowchart illustrating an operating method of a storage device according to an embodiment.

FIG. 7 is a block diagram conceptually illustrating low energy write of a storage device according to an embodiment.

FIG. 8 is a diagram illustrating threshold voltage distributions of memory cells of a power loss protection (PLP) area according to an embodiment.

FIG. 9 is a diagram for describing a program operation for memory cells of a PLP area according to an embodiment.

FIG. 10 conceptually illustrates a program operation performed for a specific memory cell of a PLP area according to an embodiment.

FIG. 11 conceptually illustrates a program operation performed for a specific memory cell of a PLP area according to an embodiment.

FIG. 12 is a diagram illustrating a program characteristic according to a size of a channel hole according to an embodiment.

FIG. 13 is a diagram illustrating a program characteristic according to a shape of a channel hole according to an embodiment.

FIG. 14 is a flowchart illustrating an operating method of a storage device according to an embodiment.

FIG. 15 illustrates an example of PLP write according to an embodiment.

FIG. 16 is a flowchart illustrating an operating method of a storage device according to an embodiment.

FIG. 17 illustrates an example of PLP write according to an embodiment.

FIG. 18 is a flowchart illustrating an operating method of a storage device according to an embodiment.

FIG. 19 illustrates an example of PLP write according to an embodiment.

FIG. 20 is a flowchart illustrating an operating method of a storage device according to an embodiment.

FIG. 21 illustrates an example of PLP write according to an embodiment.

FIG. 22 illustrates another example of PLP write according to an embodiment.

FIG. 23 is a flowchart illustrating an operating method of a storage device according to an embodiment.

FIG. 24 is a diagram illustrating threshold voltage distributions of memory cells of a normal area according to an embodiment.

FIG. 25 is a diagram for describing a program operation for memory cells of a normal area according to an embodiment.

FIG. 26 conceptually illustrates a program operation performed for a specific memory cell of a normal area according to an embodiment.

FIG. 27 conceptually illustrates a program operation performed for a specific memory cell of a normal area according to an embodiment.

FIG. 28 is a flowchart illustrating an operating method of a storage device according to an embodiment.

FIG. 29 is a cross-sectional view illustrating a memory device according to an embodiment.

## DETAILED DESCRIPTION

Below, embodiments will be described in detail with reference to the accompanying drawings. Like components are denoted by like reference numerals throughout the specification, and repeated descriptions thereof are omitted. It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to" or "directly coupled to" another element or layer, there are no intervening elements or layers present. Embodiments described herein are example embodiments, and thus, the present disclosure is not limited thereto, and may be realized in various other forms. Each example embodiment provided in the following description is not excluded from being associated with one or more features of another example or another example embodiment also provided herein or not provided herein but consistent with the present disclosure.

In the detailed description, components which are described with reference to the terms "unit", "module", "block", "~er or ~or", etc., and function blocks which are illustrated in drawings will be implemented in the form of hardware. For example, the hardware may include an electrical circuit, an electronic circuit, a processor, a computer, an integrated circuit, integrated circuit cores, a pressure sensor, an inertial sensor, a microelectromechanical system (MEMS), a passive element, or a combination thereof.

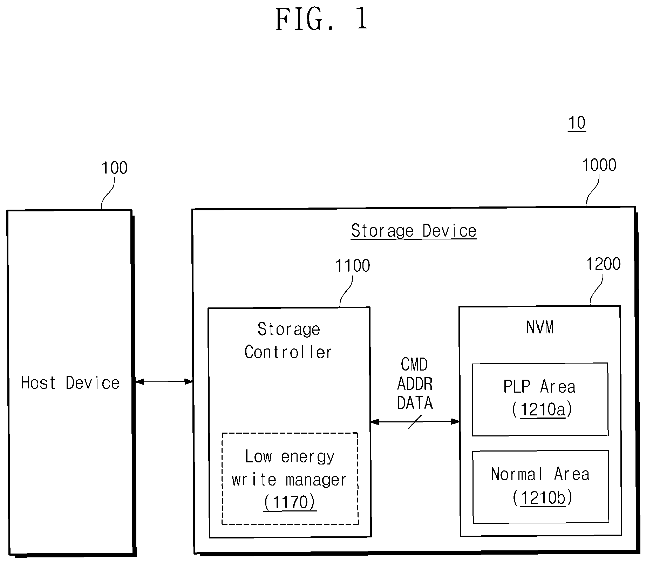

FIG. 1 is a block diagram of a storage system according to an embodiment.

Referring to FIG. 1, a storage system 10 may include a host device 100 and a storage device 1000. In an embodiment, the storage system 10 may be implemented with a computing system, which is configured to process a variety of information, such as a personal computer (PC), a notebook, a laptop, a server, a workstation, a tablet PC, a smartphone, a digital camera, and a black box.

The host device 100 may store data in the storage device 1000 or may read data stored in the storage device 1000. For example, the host device 100 may transmit a write command and write data to the storage device 1000 to store data in the storage device 1000. Alternatively, to read data stored in the storage device 1000, the host device 100 may transmit a read command to the storage device 1000 and may receive the data from the storage device 1000.

The storage device 1000 may include a storage controller 1100 and a nonvolatile memory device 1200. The storage device 1000 may operate depending on a request of the host device 100. The storage controller 1100 may operate in response to a command received from the host device 100. For example, the storage controller 1100 may receive the write command and the write data from the host device 100 and may store the write data in the nonvolatile memory device 1200 in response to the received write command. The storage controller 1100 may receive the read command from the host device 100 and may read data stored in the nonvolatile memory device 1200 in response to the received read command. The storage controller 1100 may transmit the read data to the host device 100.

The storage controller 1100 may control a low energy write manager 1170. The low energy write manager 1170 may manage the nonvolatile memory device 1200 such that the program operation is performed for a memory cell whose write energy is small. In an embodiment, the low energy write manager 1170 may be understood as a component of the storage controller 1100 or as a component including instructions (e.g., firmware) which are loaded to an internal or external memory of the storage controller 1100 and driven by the storage controller 1100.

In an embodiment, the low energy write manager 1170 may allow the storage device 1000 to operate in a low energy write mode. For example, the low energy write mode may be activated when a sudden power-off (SPO) occurs, and the low energy write manager 1170 may control the nonvolatile memory device 1200 such that power loss protection (PLP) data being processed by the storage controller 1100 are stored in memory cells having (i.e., corresponding to) low write energy from among memory cells of a PLP area 1210a. The sudden power-off may correspond to an unexpected loss of power while the storage device 1000 is in operation.

In an embodiment, in a normal write operation, the low energy write manager 1170 may control the nonvolatile memory device 1200 such that write data requested by the host device 100 are stored in memory cells having (i.e., corresponding to) low write energy from among memory cells of a normal area 1210b.

In an embodiment, the nonvolatile memory device 1200 may include a NAND flash memory device. For example, the PLP area 1210a may be implemented with a single level cell (SLC) storing one bit, and the normal area 1210b may be implemented with at least one of a multi-level cell (MLC) storing two bits, a triple level cell (TLC) storing three bits, a quadruple level cell (QLC) storing four bits, or a cell storing five or more bits.

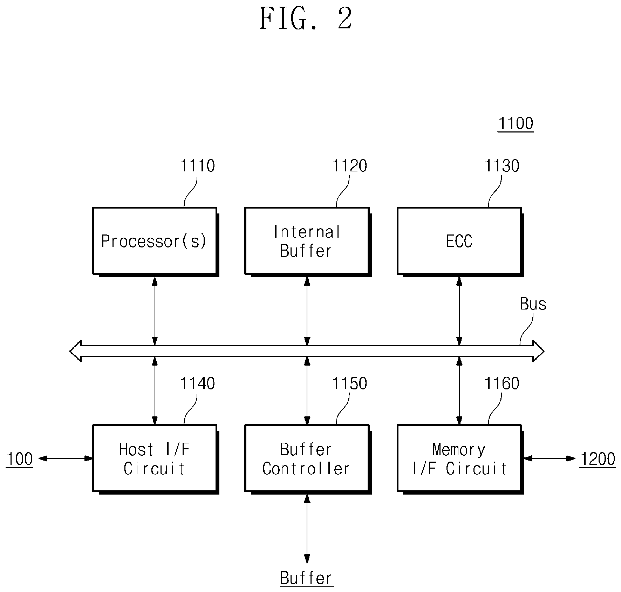

FIG. 2 illustrates a configuration of a storage controller of FIG. 1 as an example.

The storage controller 1100 includes at least one processor 1110, an internal buffer 1120, an error check and correction (ECC) engine 1130, a host interface circuit 1140, a buffer controller 1150, and a memory interface circuit 1160.

The processor 1110 controls all the operations of the storage controller 1100. The processor 1110 may drive various operating systems, firmware, software, etc., necessary to control the nonvolatile memory device 1200. For example, the processor 1110 may drive a flash translation layer for managing a mapping table in which a relationship between logical addresses and physical addresses of the nonvolatile memory device 1200 and the low energy write manager 1170 described with reference to FIG. 1.

The processor 1110 may store requests received from the host device 100 in the internal buffer 1120. The processor 1110 may generate addresses and commands for controlling the nonvolatile memory device 1200, based on the received requests. The processor 1110 may store various data for managing the storage device 1000 in the internal buffer 1120. For example, the internal buffer 1120 may include a static random access memory (SRAM) and/or a dynamic random access memory (DRAM).

The ECC engine 1130 may generate an error correction code ECC for write data to be stored in the nonvolatile memory device 1200 and may perform error correction encoding by using the error correction code ECC. The ECC engine 1130 may perform error correction decoding for read data by using the error correction code ECC read from the nonvolatile memory device 1200.

The host interface circuit 1140 may communicate with the host device 100 by using a bus having a bus format corresponding to various communication protocols. For example, the bus format may correspond to one or more of various interface protocols such as Universal Serial Bus (USB), small computer system interface (SCSI), peripheral component interconnect express (PCIe), mobile PCIe (M-PCIe), advanced technology attachment (ATA), parallel ATA (PATA), serial ATA (SATA), serial attached SCSI (SAS), integrated drive electronics (IDE), enhanced IDE (EIDE), non-volatile memory express (NVMe), and universal flash storage (UFS).

The buffer controller 1150 may provide interfacing between the storage controller 1100 and a buffer (e.g., a random access memory (RAM)). The buffer controller 1150 may access the buffer depending on a request of the processor 1110 or any other intellectual property (IP). For example, an IP may include circuitry to perform specific functions, and may have a design that includes a trade secret. For example, under control of the processor 1110, the buffer controller 1150 may temporarily record the write data to be stored in the nonvolatile memory device 1200 and/or the read data read from the nonvolatile memory device 1200 at the buffer.

The memory interface circuit 1160 may communicate with the nonvolatile memory device 1200. For example, the memory interface circuit 1160 may access the nonvolatile memory device 1200 through various signal lines. The memory interface circuit 1160 may communicate with the nonvolatile memory device 1200, based on a protocol defined in compliance with the standard or defined by a manufacturer.

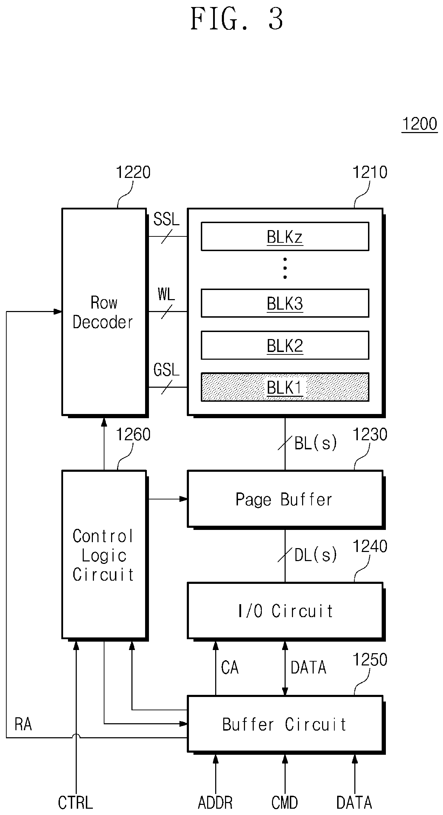

FIG. 3 is a block diagram illustrating the nonvolatile memory device 1200 according to an embodiment.

Referring to FIG. 3, the nonvolatile memory device 1200 may include a memory cell array 1210, a row decoder 1220, a page buffer 1230, an input/output circuit 1240, a buffer circuit 1250, and a control logic circuit 1260.

The memory cell array 1210 includes a plurality of memory blocks BLK1 to BLKz. Each of the memory blocks BLK1 to BLKz includes a plurality of memory cells. Each of the memory blocks BLK1 to BLKz may be connected to the row decoder 1220 through at least one ground selection line GSL, word lines WL, and at least one string selection line SSL. Some of the word lines WL may be used as dummy word lines. Each of the memory blocks BLK1 to BLKz may be connected to the page buffer 1230 through a plurality of bit lines BL. The plurality of memory blocks BLK1 to BLKz may be connected in common to the plurality of bit lines BL.

In an embodiment, each of the plurality of memory blocks BLK1 to BLKz may correspond to a unit of the erase operation. Memory cells belonging to each memory block may be erased at the same time. As another example, each of the memory blocks BLK1 to BLKz may be divided into a plurality of sub-blocks. Each of the plurality of sub-blocks may correspond to a unit of the erase operation.

In an embodiment, at least some (e.g., BLK1) of the plurality of memory blocks BLK1 to BLKz may be a memory block belonging to the PLP area 1210a, and at least some of the plurality of memory blocks BLK1 to BLKz may be a memory block belonging to the normal area 1210b.

The row decoder 1220 may be connected to the memory cell array 1210 through the ground selection lines GSL, the word lines WL, and the string selection lines SSL. The row decoder 1220 operates under control of the control logic circuit 1260.

The row decoder 1220 may decode a row address RA received from the buffer circuit 1250 and may control voltages to be applied to the string selection lines SSL, the word lines WL, and the ground selection lines GSL based on the decoded row address.

The page buffer 1230 may be connected to the memory cell array 1210 through the plurality of bit lines BL. The page buffer 1230 may be connected to the input/output circuit 1240 through a plurality of data lines DL. The page buffer 1230 operates under control of the control logic circuit 1260.

In the write operation, the page buffer 1230 may store data to be written in memory cells. The page buffer 1230 may apply voltages to the plurality of bit lines BL based on the stored data. In the read operation or in the verify read operation, which performed in the write operation or the erase operation, the page buffer 1230 may sense voltages of the bit lines BL and may store a result of the sensing.

The input/output circuit 1240 may be connected to the page buffer 1230 through the plurality of data lines DL. The input/output circuit 1240 may receive a column address CA from the buffer circuit 1250. The input/output circuit 1240 may output the data read by the page buffer 1230 to the buffer circuit 1250 depending on the column address CA. The input/output circuit 1240 may transfer the data received from the buffer circuit 1250 to the page buffer 1230, depending the column address CA.

The buffer circuit 1250 may receive a command CMD and an address ADDR from the storage controller 1100 (refer to FIG. 1). The buffer circuit 1250 may operate under control of the control logic circuit 1260. The buffer circuit 1250 may transfer the command CMD to the control logic circuit 1260. The buffer circuit 1250 may transfer the row address RA of the address ADDR to the row decoder 1220 and may transfer the column address CA of the address ADDR to the input/output circuit 1240. The buffer circuit 1250 may exchange data "DATA" with the input/output circuit 1240.

The control logic circuit 1260 may receive a control signal CTRL from the storage controller 1100 (refer to FIG. 1). The control logic circuit 1260 may allow the buffer circuit 1250 to route the command CMD, the address ADDR, and the data "DATA".

The control logic circuit 1260 may decode the command CMD received from the buffer circuit 1250 and may control the nonvolatile memory device 1200 depending on the decoded command.

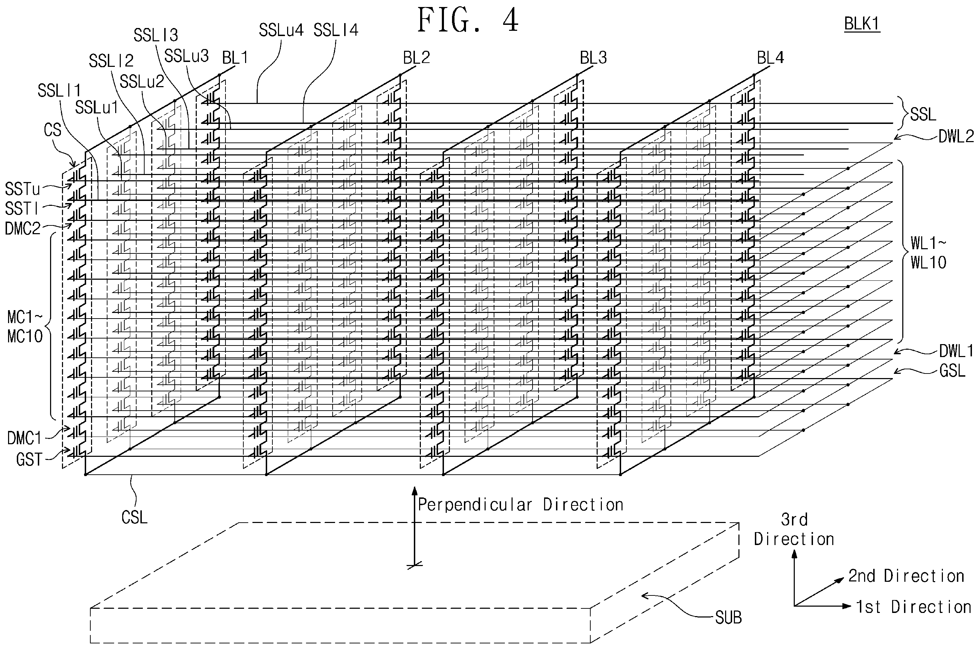

FIG. 4 illustrates an example of the memory block BLK1 according to an embodiment.

Referring to FIG. 4, a plurality of cell strings CS may be arranged in rows and columns on a substrate SUB along a first direction, a second direction, and a third direction. The plurality of cell strings CS may be connected in common with a common source line CSL formed on (or in) the substrate SUB. In FIG. 4, a location of the substrate SUB is depicted as an example for better understanding of the structure of the memory block BLK1.

Cell strings of each row may be connected in common to the ground selection line GSL and may be connected to a corresponding string selection line among first to fourth upper string selection lines SSLu1 and SSLu4 and a corresponding string selection line among first to fourth lower string selection lines SSLl1 to SSLl4. Cell strings of each column may be connected to a corresponding bit line among first to fourth bit lines BL1 to BL4. To prevent a drawing from being complicated, cell strings connected to the second and third string selection lines SSL2l, SSL2u, SSL3l, and SSL3u are depicted to be blurred.

Each cell string may include at least one ground selection transistor GST connected to the ground selection line GSL, a first dummy memory cell DMC1 connected to a first dummy word line DWL1, first to tenth memory cells MC1 to MC10 respectively connected to first to tenth word lines WL1 to WL10, a second dummy memory cell DMC2 connected to a second dummy word line DWL2, and upper and lower string selection transistors SSTu and SSTI respectively connected to corresponding upper and lower string selection lines.

In each cell string CS, the ground selection transistor GST, the first dummy memory cell DMC1, the first to tenth memory cells MC1 to MC10, the second dummy memory cell DMC2, and the upper and lower string selection transistors SSTu and SSTI may be connected in series and may be sequentially stacked along the third direction which is perpendicular to the substrate SUB.

The memory block BLK1 is provided as a three-dimensional (3D) memory array. The 3D memory array is monolithically formed in one or more physical levels of arrays of memory cells MC having an active area disposed above a silicon substrate and a circuitry associated with the operation of those memory cells MC. The circuitry associated with the operation of the memory cells MC may be located above or within a substrate. The term "monolithic" indicates that layers of each level of the 3D array are directly deposited on the layers of each underlying level of the 3D memory array.

As an example, the 3D memory array includes vertical cell strings CS (or NAND strings) which are vertically oriented such that at least one memory cell is located over another memory cell. The at least one memory cell may include a charge trap layer. Each cell string further includes at least one selection transistor placed on the memory cells MC. The at least one selection transistor may have the same structure as the memory cells MC and may be formed uniformly with the memory cells MC.

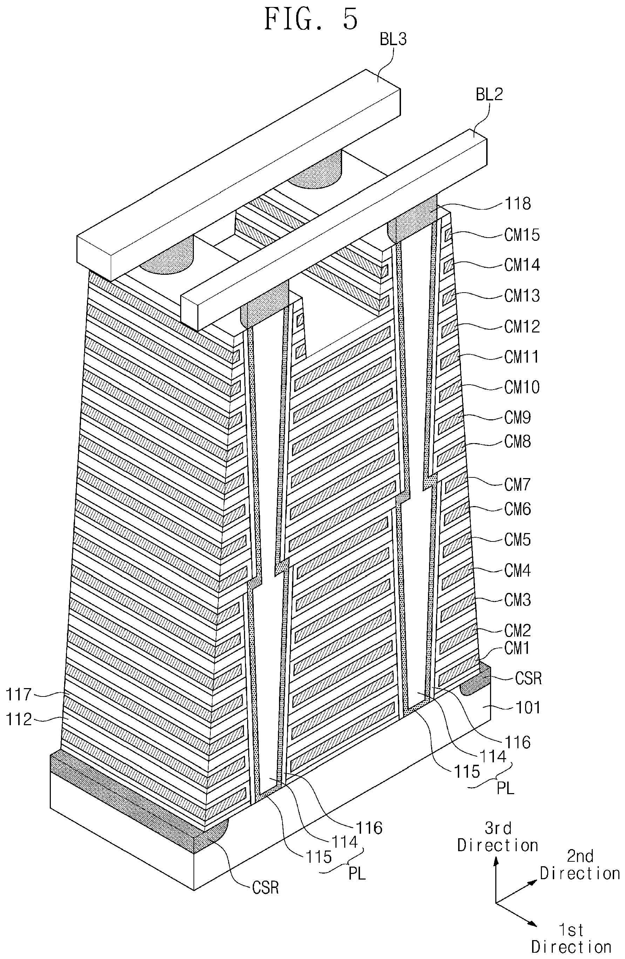

FIG. 5 is a cross-sectional view illustrating an example of the cell strings CS of the memory block BLK1 of FIG. 4, which correspond to the second and third bit lines BL2 and BL3. Referring to FIGS. 4 and 5, there are provided common source regions CSR which extend along the first direction and are spaced apart from each other along the second direction.

The common source regions CSR may be connected in common to form the common source line CSL. In an embodiment, a substrate 101 may include a P-type semiconductor material. The common source regions CSR may include an N-type semiconductor material. For example, a conductive material for increasing the conductivity of the common source line CSL may be provided on the common source region CSR.

Pillars PL which are perpendicular to the substrate 101 in the third direction may be provided between the common source regions CSR. Each of the pillars PL may include an inner material 114, a channel layer 115, and a first insulating layer 116.

The inner material 114 may include an insulating material or an air gap. The channel layer 115 may include a P-type semiconductor material or an intrinsic semiconductor material. The first insulating layer 116 may include one or more insulating layers (e.g., different insulating layers) such as a silicon oxide layer, a silicon nitride layer, and an aluminum oxide layer.

Insulating layers 112 and conductive materials CM1 to CM15 may be alternately stacked on the substrate 101 along the third direction perpendicular to the substrate 101 and may surround the pillars PL. In an embodiment, the insulating layers 112 may include silicon oxide or silicon nitride.

A second insulating layer 117 may be placed between the pillars PL and the conductive materials CM1 to CM15 and between the conductive materials CM1 to CM15 and the insulating layer 112. In each of the pillars PL, the first insulating layer 116 and the second insulating layer 117 may form an information storage layer when coupled adjacent to each other. For example, the first insulating layer 116 and the second insulating layer 117 may include oxide-nitride-oxide (ONO) or oxide-nitride-aluminum (ONA). The first insulating layer 116 and the second insulating layer 117 may form a tunneling insulating layer, a charge trap layer, and a blocking insulating layer.

Bit line contacts 118 may be provided on the pillars PL. In an embodiment, the bit line contacts 118 may include an N-type semiconductor material (e.g., silicon). The bit lines BL2 and BL3 which extend along the second direction and are spaced apart from each other along the first direction are provided on the bit line contacts 118. The bit lines BL2 and BL3 may be connected to the bit line contacts 118.

The pillars PL form the cell strings CS together with the first and second insulating layers 116 and 117 and the conductive materials CM1 to CM15. Each of the pillars PL forms a cell string together with the first and second insulating layers 116 and 117 and the conductive materials CM1 to CM15, which are adjacent thereto. The first conductive material CM1 may form the ground selection transistors GST together with the first and second insulating layers 116 and 117 and the channel layers 115 adjacent thereto. The first conductive material CM1 may extend along the first direction to form the ground selection line GSL.

The second conductive material CM2 may form the first dummy memory cells DMC1 together with the first and second insulating layers 116 and 117 and the channel layers 115 adjacent thereto. The second conductive material CM2 may extend along the first direction to form the first dummy word line DWL1.

The third to twelfth conductive materials CM3 to CM12 may form the first to tenth memory cells MC1 to MC10 together with the first and second insulating layers 116 and 117 and the channel layers 115 adjacent thereto. The third to twelfth conductive materials CM3 to CM12 may extend along the first direction to form the first to tenth word lines WL1 to WL10.

The thirteenth conductive material CM13 may form the second dummy memory cells DMC2 together with the first and second insulating layers 116 and 117 and the channel layers 115 adjacent thereto. The thirteenth conductive material CM13 may extend along the first direction to form the second dummy word line DWL2.

The fourteenth and fifteenth conductive materials CM14 and CM15 may form the lower and upper string selection transistors SSTl and SSTu together with the first and second insulating layers 116 and 117 and the channel layers 115 adjacent thereto. The fourteenth and fifteenth conductive materials CM14 and CM15 may extend along the first direction to form lower and upper string selection lines.

As illustrated in FIG. 5, each of the pillars PL may include a first portion adjacent to the substrate 101 and a second portion on the first portion. Due to the process of manufacturing a nonvolatile memory device, for example, a flash memory device, in the first portion corresponding to the first to seventh conductive materials CM1 to CM7, the width or cross-sectional area of the pillar PL may decrease as the distance from the substrate 101 decreases and may increase as the distance from the substrate 101 increases.

Likewise, in the second portion corresponding to the eighth to fifteenth conductive materials CM8 to CM15, the width or cross-sectional area of the pillar PL may decrease as the distance from the substrate 101 decreases and may increase as the distance from the substrate 101 increases.

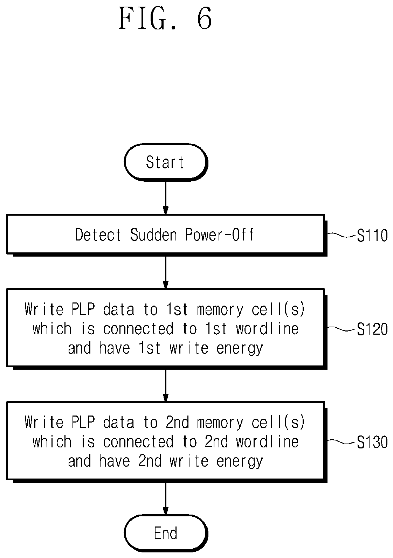

FIG. 6 is a flowchart illustrating an operating method of the storage device 1000 according to an embodiment.

Referring to FIGS. 1, 2, and 6 together, in operation S110, the storage controller 1100 may detect sudden power-off. For example, the sudden power-off may be detected by monitoring power stability.

When the sudden power-off occurs, the storage controller 1100 may store data (i.e., PLP data) being processed, which is stored in the buffer or the internal buffer 1120, in the PLP area 1210a, which is called PLP write or PLP program. In detail, the PLP write is for later processing data whose processing is not yet completed due to the sudden cutoff of the power supply from the external. In an embodiment, power for the PLP write may be provided by a super capacitor provided in a storage device.

In operation S120, the storage controller 1100 may write the PLP data in a first memory cell having (i.e., corresponding to) first write energy and connected to a first word line. That is, the first write energy may indicate energy for programming data in one memory cell (i.e., the first memory cell) connected to the first word line. However, in another embodiment, the first write energy may indicate energy for programming a plurality of memory cells connected to one word line.

In operation S130, the storage controller 1100 may write the PLP data in a second memory cell having (i.e., corresponding to) second write energy and connected to a second word line. Likewise, the second write energy may indicate energy for programming data in one memory cell (i.e., the second memory cell) connected to the second word line. However, in another embodiment, the second write energy may indicate energy for programming a plurality of memory cells connected to one word line. In an embodiment, the second word line may be a word line which is not adjacent to the first word line. However, embodiments are not limited thereto. For example, the second word line may be a word line which is adjacent to the first word line. In an embodiment, a value of the second write energy may be greater than a value of the first write energy.

The first write energy and the second write energy described above may not indicate energy which is actually required to program a memory cell. That is, a memory manufacturer may set a specific reference value; in this case, when energy necessary to program a memory cell is less than the reference value, the corresponding memory cell may be regarded as having (i.e., corresponding to) the first write energy. In contrast, when energy necessary to program a memory cell is equal to or greater than the reference value, the corresponding memory cell may be regarded as having (i.e., corresponding to) the second write energy.

The write energy required to program each memory cell of the PLP area 1210a may vary due to various reasons such as a location of a memory cell, a program characteristic of a memory cell, and a manufacturing process of a memory cell. According to embodiments, when the sudden power-off occurs, the PLP write may be performed in order from a memory cell having small write energy to a memory cell having large write energy. Accordingly, it may be possible to efficiently use the limited energy of the super capacitor, and it may also be possible to reduce a PLP write time. The factor of determining a value of the write energy and a policy of the PLP write according to embodiments will be described in detail later.

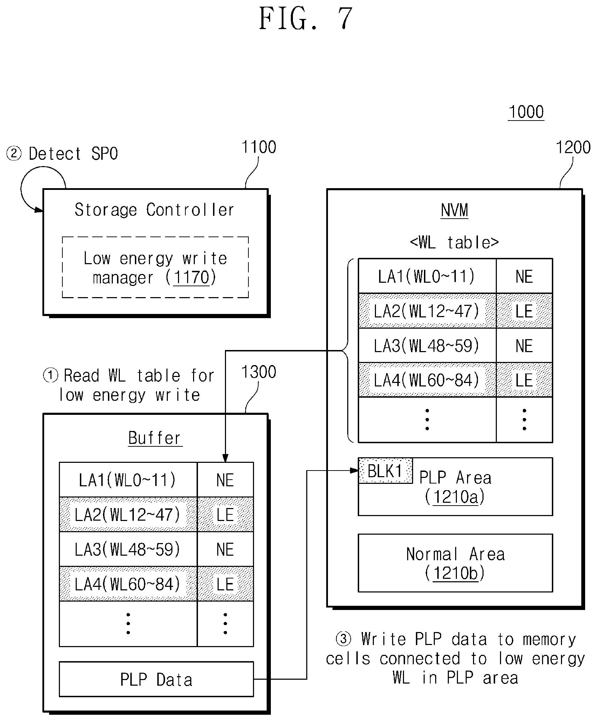

FIG. 7 is a block diagram conceptually illustrating low energy write of the storage device 1000 according to an embodiment.

While the storage device 1000 operates, the storage controller 1100 may load a word line table stored in a meta area of the nonvolatile memory device 1200 to a buffer 1300. In an embodiment, the meta area may indicate an area of the storage space of the nonvolatile memory device 1200, which is not allocated to the user. As a contrasting concept, the normal area 1210b may indicate an area in which the user data are stored. In an embodiment, the PLP area 1210a may be a portion of the meta area. However, embodiments are not limited thereto. For example, the PLP area 1210a may be included in an over-provisioning (OP) area independent of the meta area and the normal area 1210b.

In an embodiment, the word line table may include write energy information of memory cells of the PLP area 1210a. In detail, the word line table may include a logical address of a memory cell and information about whether normal write energy NE is required to program a memory cell or low write energy LE is required to program a memory cell.

However, the case where the write energy of each of all the memory cells is managed by using a table may be the most desirable in terms of the efficient use of the limited energy stored in the super capacitor. However, because it is not efficient to manage the write energy information about all the memory cells, to manage the write energy information in units of word line may be more efficient.

In addition, memory cells connected to the same word line may generally have the same characteristic. For example, when an arbitrary memory cell connected to the word line has low write energy, all the memory cells connected to the word line may also mostly have low write energy. Accordingly, as illustrated in the word line table of FIG. 7, it may be possible to manage the write energy (i.e., normal write energy (NE) information or low write energy (LE) information) in units of word line, which is more efficient.

After the word line table is loaded to the buffer 1300, the storage controller 1100 may perform various processing on data stored in the buffer 1300. However, when the sudden power-off occurs in a state where data processing is not completed, at least a portion of the data being processed (i.e., data stored in the buffer 1300) may be PLP data which should be stored in the PLP area 1210a.

The storage controller 1100 may determine a logical address of a word line targeted for the PLP write by referring to the word line table loaded to the buffer 1300. The flash translation layer may translate a logical address of the word line targeted for the PLP write into a physical address. The storage controller 1100 may perform the PLP write for memory cells connected to word lines (e.g., WL12 to WL47 and WL60 to WL84) having (i.e., corresponding to) the low write energy LE from among word lines of the first memory block BLK1.

In an embodiment, to perform the PLP write, a normal write command may be used, or a separate command (e.g., a vendor-specific command) may be used. For example, when the sudden power-off occurs in the low energy write mode, the above PLP write may be performed depending on the write command or the separate command. However, embodiments are not limited thereto. For example, when the sudden power-off occurs regardless of an operating mode, the above PLP write may be performed as a default operation.

As described above, the word line table may be loaded to the buffer 1300 before the sudden power-off occurs. However, in another embodiment, when the sudden power-off occurs, the storage controller 1100 may read the word line table stored in the meta area by using the energy stored in the super capacitor, so as to be loaded to the buffer 1300. The storage controller 1100 may perform the PLP write based on the read word line table.

According to the above manner, because the PLP write for memory cells having (i.e., corresponding to) low write energy is performed, the limited energy of the super capacitor may be efficiently used, and in addition, the PLP write time may be reduced.

After the sudden power-off is terminated (i.e., after a power is again supplied to a storage device), the storage controller 1100 may read the PLP data present in the PLP area 1210a so as to be stored in the buffer 1300, and the storage controller 1100 may complete the processing of the PLP data suspended before the sudden power-off.

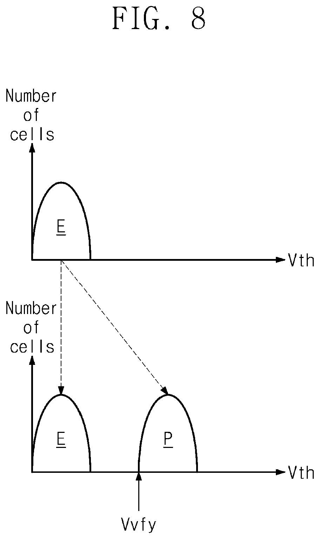

FIG. 8 is a diagram illustrating threshold voltage distributions of memory cells of the PLP area 1210a of FIG. 7. In the distribution diagram of FIG. 8, the horizontal axis represents a threshold voltage of a memory cell, and the vertical axis represents the number of memory cells.

Referring to FIGS. 3 and 8, the nonvolatile memory device 1200 may program the PLP data in memory cells by controlling threshold voltages of memory cells of the memory block BLK1 of the PLP area 1210a. For example, the memory cells may be programmed to have one of an erase state "E" and a program state "P".

The nonvolatile memory device 1200 may verify program states of memory cells based on a verify voltage Vvfy. For example, the nonvolatile memory device 1200 may verify whether memory cells corresponding to the program state "P" are normally programmed, by using the verify voltage Vvfy. The nonvolatile memory device 1200 may read data stored in the memory cells by sensing program states (i.e., threshold voltages) of the memory cells.

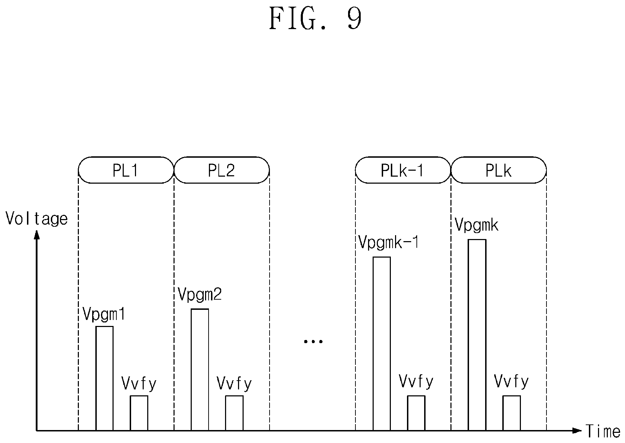

FIG. 9 is a diagram for describing a program operation for memory cells of the PLP area 1210a of FIG. 7. The program operation to be described in an embodiment of FIG. 9 may be associated with determining a program characteristic (i.e., the low write energy LE or the normal write energy NE) for each word line in a test phase of the nonvolatile memory device 1200.

In an embodiment, the nonvolatile memory device 1200 according to an embodiment may program memory cells of the PLP area 1210a by sequentially performing a plurality of program loops based on an incremental step pulse programming (ISPP) manner.

Referring to FIG. 9, the nonvolatile memory device 1200 may perform the program operation through a plurality of program loops PL1 to PLk. Each of the plurality of program loops PL1 to PLk may include a program phase and a verify phase. The program phase may include applying a program voltage (e.g., each of Vpgm1 to Vpgmk) to a selected word line. The verify phase may include applying the verify voltage Vvfy to the selected word line.

In the first program loop PL1, the first program voltage Vpgm1 may be applied to memory cells to be programmed to the program state "P" from among memory cells connected to the selected word line, and the verify voltage Vvfy for verifying whether the memory cells are program-passed may be applied thereto. The program-passed memory cells which are inhibit cells may be program-inhibited in a next program loop.

In the second program loop PL2, the second program voltage Vpgm2 may be applied to memory cells to be programmed to the program state "P" from among the remaining memory cells of the selected word line other than the inhibit cells, and the verify voltage Vvfy for verifying whether the memory cells are program-passed may be applied thereto.

As the program loops PLk-1 and PLk are repeated to be similar to the above program loops, the programming of the selected memory cells may be completed.

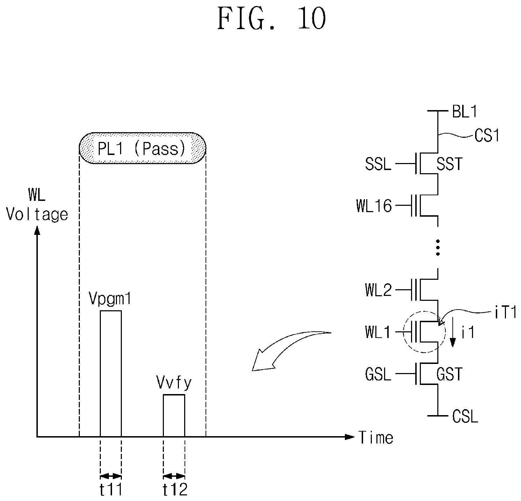

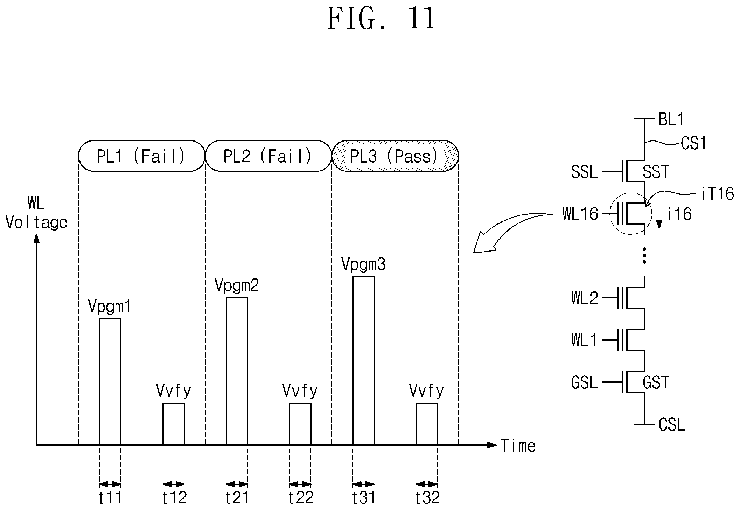

FIG. 10 conceptually illustrates a program operation performed for a specific memory cell of the PLP area 1210a (refer to FIG. 7). FIG. 11 conceptually illustrates a program operation performed for a specific memory cell of the PLP area 1210a (refer to FIG. 7).

Referring to FIG. 10, first, it is assumed that the program operation is performed for a memory cell connected to the first word line WL1 from among memory cells of the cell string CS1 connected to the bit line BL1.

The program operation for the memory cell may be performed based on the ISPP manner, and the memory cell may be program-passed in one program loop PL1. In this case, the electrical energy which is consumed in the program operation for the memory cell may be expressed by Equation 1 below. In Equation 1 below, iT1 may be a tunneling current flowing between a body and a gate electrode of a transistor connected to the first word line WL1, and i1 may be a current flowing a drain electrode and a source electrode of the transistor connected to the first word line WL1. However, it should be understood that the current flowing between the drain electrode and the source electrode of the transistor when the program voltage is applied is omitted from Equation 1 for accurate energy calculation because the current is considered together but the magnitude of the current is less than the tunneling current iT1.

[Equation 1]
$$E1 = (Vpgm1 \times iT1 \times t11) + (Vvfy \times i1 \times t12)$$

Referring to FIG. 11, it is assumed that the program operation is performed for a memory cell connected to the sixteenth word line WL16 from among the memory cells of the cell string CS1 connected to the bit line BL1.

The program operation for the memory cell may be performed based on the ISPP manner, and the memory cell may be program-passed after three program loops PL1 to PL3 are performed. In this case, the electrical energy which is consumed in the program operation for the memory cell may be expressed by Equation 2 below. In Equation 2 below, iT16 may be a tunneling current flowing between a body and a gate electrode of a transistor connected to the sixteenth word line WL16, and i16 may be a current flowing a drain electrode and a source electrode of the transistor connected to the sixteenth word line WL16. In Equation 2 below, the description is given as the same tunneling current iT16 flows in each program loop; however, because magnitudes of the program voltage in respective program loops are different from each other, magnitudes of the tunneling current iT16 in respective program loops may be different from each other.

[Equation 2]
$$E16 = (Vpgm1 \times iT16 \times t11) + (Vvfy \times i16 \times t12) + (Vpgm2 \times iT16 \times t21) + (Vvfy \times i16 \times t22) + (Vpgm3 \times iT16 \times t31) + (Vvfy \times i16 \times t32)$$

Comparing Equation 1 and Equation 2, it may be understood that the electrical energy which is required to program the memory cell connected to the first word line WL1 is less than the electrical energy which is required to program the memory cell connected to the sixteenth word line WL16.

Also, because memory cells connected to the same word line mostly have the same program characteristic, a program characteristic (i.e., LE or NE) of memory cells connected to a specific word line may be determined by measuring the electrical energy required to program a memory cell connected to one word line. For example, each of the memory cells connected to the first word line WL1 of FIG. 10 may be determined as having (i.e., corresponding to) the low write energy LE, and each of the memory cells connected to the sixteenth word line WL16 of FIG. 11 may be determined as having (i.e., corresponding to) the normal write energy NE.

In an embodiment, the level and application time of the program voltage Vpgm and the level and application time of the verify voltage Vvfy may be obtained by controlling a voltage generator generating a program voltage and a verify voltage, and the intensities of the tunneling currents iT1 and iT16 and the currents i1 and i16 may be obtained through a separate measurement device in the test phase.

Through the above, how to determine a program characteristic of a memory cell based on the energy consumed in the execution of the program loop is described. However, in other embodiments, any other factor(s) may be alternatively considered or may be additionally considered.

In an embodiment, it is assumed that the energy required to program the memory cells connected to the first word line WL1 is equal to the energy required to program the memory cells connected to the sixteenth word line WL16. However, intensities of the program voltage applied in respective program loops may be different from each other. In this case, a word line connected to memory cells to which a low program voltage is applied may be determined as having (i.e., corresponding to) the low write energy LE, and a word line connected to memory cells to which a high program voltage is applied may be determined as having (i.e., corresponding to) the normal write energy NE. It will be appreciated that each of the two word lines are capable of being determined as having (i.e., corresponding to) the low write energy LE depending on a policy.

In an embodiment, the number of program loops necessary for the program pass of the memory cell may be considered to determine a program characteristic of a memory cell. For example, with respect to FIG. 10, because only one program loop is performed, the memory cells connected to the first word line WL1 may be determined as having (i.e., corresponding to) the low write energy LE. In contrast, with respect to FIG. 11, because three program loops are performed, the memory cells connected to the sixteenth word line WL16 may be determined as having (i.e., corresponding to) the normal write energy NE.

In an embodiment, the level of the program voltage Vpgm may be considered to determine a program characteristic of a memory cell. For example, even though the number of program loops required to program the memory cells of the first word line WL1 is equal to the number of program loops required to program the memory cells of the sixteenth word line WL16, the level of the program voltage may differ depending on a location of a memory cell. In this case, memory cells connected to a word line having a low program voltage in the same program loop may be determined as having (i.e., corresponding to) the low write energy LE, and memory cells connected to a word line having a high program voltage in the same program loop may be determined as having (i.e., corresponding to) the normal write energy NE. It will be appreciated that each of the two word lines are capable of being determined as having (i.e., corresponding to) the low write energy LE depending on a policy.

In an embodiment, due to factors such as a location of a memory cell, a characteristic of a memory cell, and a manufacturing process, memory cells connected to a specific word line may be program-passed through only one program loop. In the process of testing the nonvolatile memory device 1200, memory cells of a word line program-passed through only one program loop may be regarded as having very high reliability, and a separate verify operation for the memory cells of the word line may not be performed. That is, the memory cells not experiencing the verify operation may be determined as having (i.e., corresponding to) the low write energy LE.

In an embodiment, intensities of the tunneling currents iT1 and iT16 (refer to FIGS. 10 and 11) and/or the currents i1 and i16 of the transistors of the cell string CS1 may be considered to determine a program characteristic of a memory cell. For example, when the number of program loops required to program the memory cells connected to the first word line WL1 is equal to the number of program loops required to program the memory cells connected to the sixteenth word line WL16, intensities of tunneling currents flowing through transistors respectively connected to the word lines WL1 and WL16 and/or intensities of currents flowing through the transistors may be additionally considered. When the intensity of the tunneling current iT1 of the memory cell connected to the first word line WL1 is less than the intensity of the tunneling current iT16 of the memory cell connected to the sixteenth word line WL16, the memory cells connected to the first word line WL1 may be determined as having (i.e., corresponding to) the low write energy LE, and the memory cells connected to the sixteenth word line WL16 may be determined as having (i.e., corresponding to) the normal write energy NE. It will be appreciated that each of the two word lines are capable of being determined as having (i.e., corresponding to) the low write energy LE depending on a policy.

As discussed above, as an example, there are described some of possible combinations of factors for determining a program characteristic of a memory cell, such as a program voltage, a voltage application time, a tunneling current of a memory cell, the number of program loops, and whether to skip a verify voltage. However, it should be understood that the above factors may be considered independently of each other or a program characteristic of a memory cell may be determined through different factors capable of being combined from among the above factors.

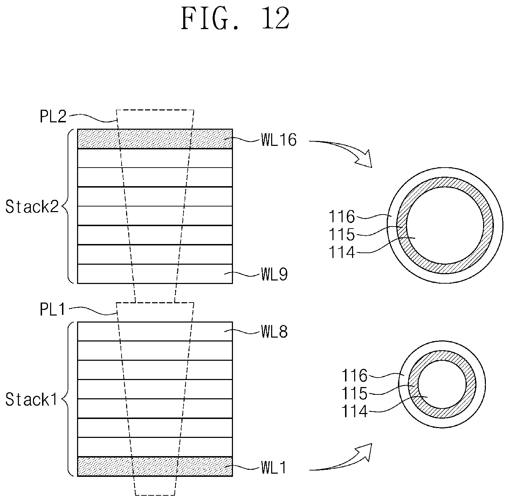

FIG. 12 is a diagram illustrating a program characteristic according to a size of a channel hole. FIG. 12 shows a simplified cross-sectional view of FIG. 5; in an embodiment, there is illustrated a cell string implemented in a 2-stack structure and including 16 memory cells. As shown, the 2-stack structure includes first stack structure Stack1, which corresponds to a first portion PL1, and a second stack structure Stack2, which corresponds to a second portion PL2.

Referring to FIG. 12, due to an issue of a manufacturing process of a memory device, the width or cross-sectional area of a first portion PL1 may become narrower as the distance from the substrate decreases and may become wider as the distance from the substrate increases. Also, the width or cross-sectional area of a second portion PL2 may become narrower as the distance from the substrate decreases and may become wider as the distance from the substrate increases.

Because the size of the memory cell increases as the width or cross-sectional area of the pillar increases, additional energy may be required to program the memory cell. This may be caused due to an increase in a level of a program voltage, an increase in a program time, an increase in a tunneling current, etc. In contrast, because the size of the memory cell decreases as the width or cross-sectional area of the pillar decreases, less energy may be required to program the memory cell. This may be caused due to a decrease in a level of a program voltage, a decrease in a program time, a decrease in a tunneling current, etc.

According to the above description, as the width or cross-sectional area of the pillar decreases (i.e., as the distance from the substrate decreases), low write energy may be required to program the memory cells of the PLP area 1210a (refer to FIG. 1). In contrast, as the width or cross-sectional area of the pillar increases (i.e., as the distance from the substrate increases), high write energy may be required to program the memory cells of the PLP area 1210a (refer to FIG. 1).

In an embodiment, a memory cell in which the width or cross-sectional area of the pillar is less than a reference value may be determined as having (i.e., corresponding to) the low write energy LE. In contrast, a memory cell in which the width or cross-sectional area of the pillar is equal to or greater than the reference value may be determined as having (i.e., corresponding to) the normal write energy NE.

According to the above determination criterion, the first word line WL1 and the second word line WL2 of the first portion PL1 of the pillar and the ninth word line WL9 and the tenth word line WL10 of the second portion PL2 of the pillar may be determined as having (i.e., corresponding to) the low write energy LE, and the remaining word lines may be determined as having (i.e., corresponding to) the normal write energy NE. Of course, the number of word lines determined as having (i.e., corresponding to) the low write energy LE may be variable depending on a policy.

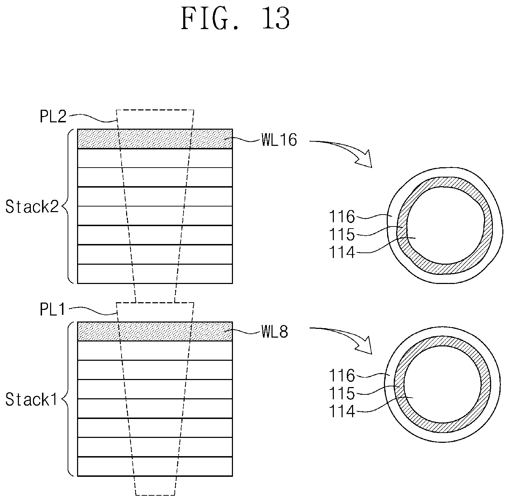

FIG. 13 is a diagram illustrating a program characteristic according to a shape of a channel hole. FIG. 13 shows a simplified cross-sectional view of FIG. 5; in an embodiment, there is illustrated a cell string implemented in a 2-stack structure and including 16 memory cells. As shown, the 2-stack structure includes first stack structure Stack1, which corresponds to a first portion PL1, and a second stack structure Stack2, which corresponds to a second portion PL2.

Referring to FIG. 13, due to an issue of a manufacturing process of a memory device, shapes of components (i.e., the inner material 114, the channel layer 115, and the first insulating layer 116) of the cross-section of the pillar may not be a complete circle. For example, the cross-section of the pillar may be wobbly or irregular, and in this regard may not have smooth edges. For example, the components of the cross-section of the first portion PL1 of the pillar may be a complete circle near the eighth word line WL8.

However, the components of the cross-section of the second portion PL2 of the pillar may not be a complete circle near the sixteenth word line WL16 and may have heavy striation. In this case, the strong electric field may be applied to the memory cell connected to the sixteenth word line WL16 in the program operation, and the energy required to program the memory cell connected to the sixteenth word line WL16 may be small compared to the eighth word line WL8. Accordingly, even though the height of the first portion PL1 of the pillar, which the eighth word line WL8 occupies, is equal to the height of the second portion PL2 of the pillar, which the sixteenth word line WL16 occupies, the memory cell connected to the eighth word line WL8 may be determined as having (i.e., corresponding to) the normal write energy NE; in contrast, the memory cell connected to the sixteenth word line WL16 may be determined as having (i.e., corresponding to) the low write energy LE.

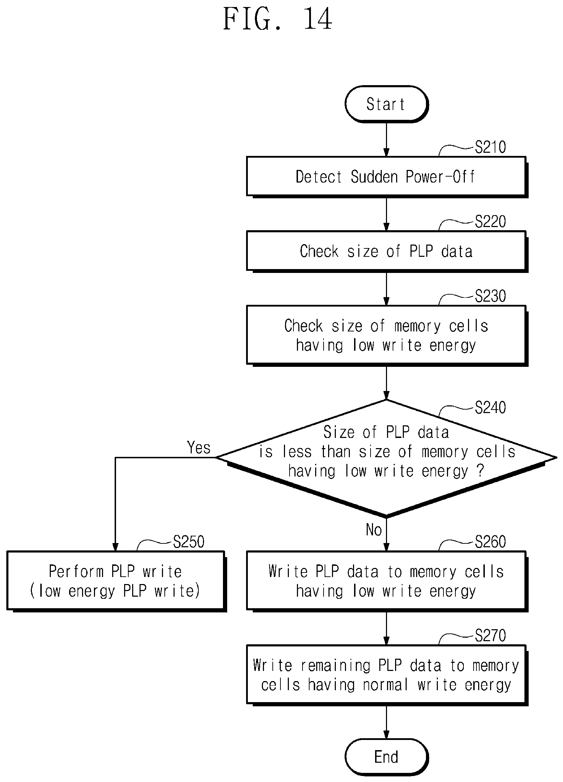

FIG. 14 is a flowchart illustrating an operating method of the storage device 1000 according to an embodiment.

Referring to FIGS. 1, 2, and 14 together, in operation S210, the storage controller 1100 may detect sudden power-off. When the sudden power-off occurs, the storage controller 1100 may store data (i.e., PLP data) being processed (i.e., data stored in the buffer or the internal buffer 1120) in the PLP area 1210a.

The low energy write manager 1170 may check the size of the PLP data (S220) and may check the size of memory cells having (i.e., corresponding to) the low write energy LE (S230).

The low energy write manager 1170 may determine whether the size of the PLP data is less than the size of the memory cells having (i.e., corresponding to) the low write energy LE.

When the size of the PLP data is less than the size of the memory cells having (i.e., corresponding to) the low write energy LE (Yes in operation S240), the PLP write for the memory cells having (i.e., corresponding to) the low write energy LE may be performed. In this case, because all the PLP data are programmed in the memory cells having (i.e., corresponding to) the low write energy LE, the case where the PLP data are programmed in memory cells having (i.e., corresponding to) the normal write energy NE may not occur.

In contrast, when the size of the PLP data is greater than or equal to the size of the memory cells having (i.e., corresponding to) the low write energy LE (No in operation S240), in operation S260, the storage controller 1100 may write the PLP data in memory cells having (i.e., corresponding to) the low write energy LE. All available memory cells having (i.e., corresponding to) the low write energy LE may be filled with the PLP data.

In operation S270, the storage controller 1100 may write the remaining PLP data, which are not yet written, in memory cells having (i.e., corresponding to) the normal write energy NE.

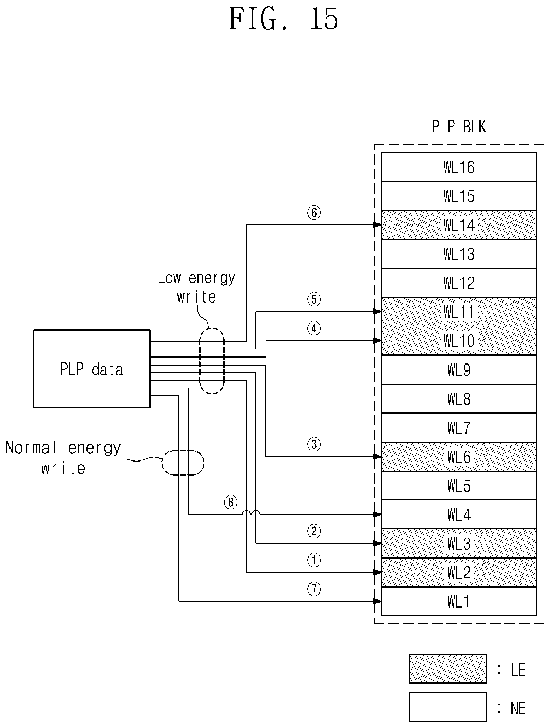

FIG. 15 illustrates an example of PLP write according to the method described with reference to FIG. 14.

Referring to FIG. 15, a PLP block in which the PLP data are stored may include word lines WL2, WL3, WL6, WL10, WL11, and WL14 having (i.e., corresponding to) the low write energy LE and the remaining word lines having (i.e., corresponding to) the normal write energy NE.

According to the operating method described with reference to FIG. 14, a storage controller may detect sudden power-off and may determine whether the size of the PLP data is greater than the size of memory cells having (i.e., corresponding to) the low write energy LE.

The storage controller may sequentially perform the PLP write for memory cells connected to the word lines WL2, WL3, WL6, WL10, WL11, and WL14 having (i.e., corresponding to) the low write energy LE from a lower word line number. However, in another embodiment, the storage controller may perform the PLP write in a reverse order from a high word line number.

When the PLP write for the word lines having (i.e., corresponding to) the low write energy LE is terminated, the storage controller may perform the PLP write for the word lines having (i.e., corresponding to) the normal write energy NE. An embodiment in which the PLP write for the word lines WL1 and WL4 is performed is illustrated.

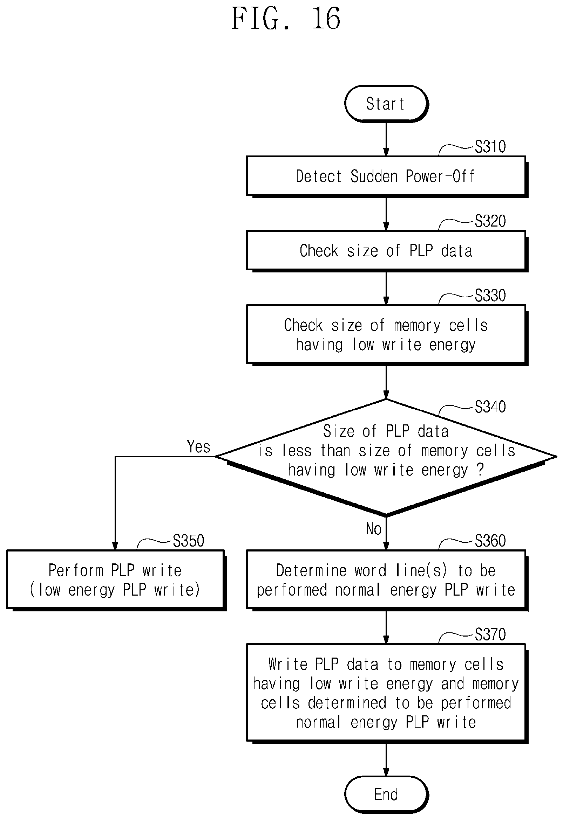

FIG. 16 is a flowchart illustrating an operating method of the storage device 1000 according to an embodiment.

The operating method of FIG. 16 may be mostly similar to that of FIG. 14, and operation S310 to operation S340 may be the same as operation S210 to operation S240 of FIG. 14. A difference, that is, operations of FIG. 16 different from the operations described with reference to FIG. 14, will be described.

In operation S360, the storage controller 1100 may determine word lines targeted for normal write energy PLP write. The reason is as follows. Because the capacity of memory cells having (i.e., corresponding to) the low write energy LE is less than the size of the PLP data, it is necessary to reserve, in advance, an additionally required size of memory cells having (i.e., corresponding to) the normal write energy NE such that the PLP write is performed in one lump.

In operation S370, the storage controller may perform the PLP write for all the memory cells having (i.e., corresponding to) the low write energy LE and memory cells, which are determined as being targeted for the normal write energy PLP write, depending on word line numbers (or in a reverse order).

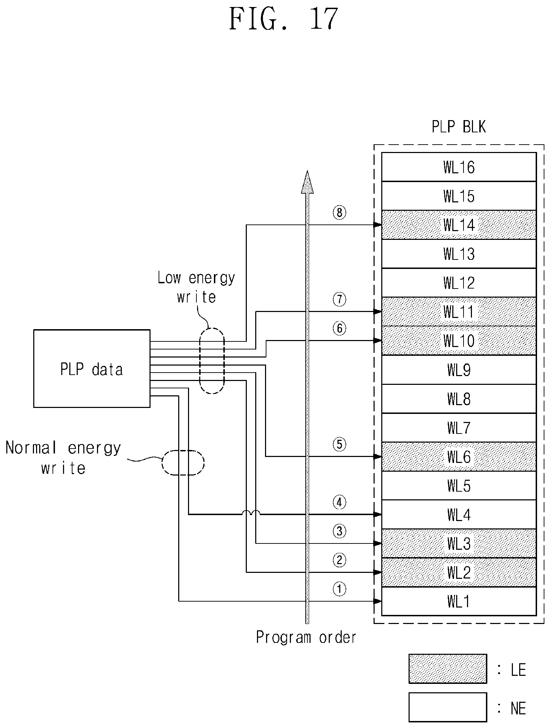

FIG. 17 illustrates an example of PLP write according to the method described with reference to FIG. 16.

Referring to FIG. 17, a PLP block in which the PLP data are stored may include word lines WL2, WL3, WL6, WL10, WL11, and WL14 having (i.e., corresponding to) the low write energy LE and the remaining word lines having (i.e., corresponding to) the normal write energy NE.

According to the operating method described with reference to FIG. 16, a storage controller may detect sudden power-off and may determine that the size of the PLP data is greater than the size of memory cells having (i.e., corresponding to) the low write energy LE.

The storage controller 1100 may determine the word lines WL1 and WL4 targeted for normal PLP write. However, embodiments are not limited thereto. The storage controller 1100 may select arbitrary word lines among the word lines having (i.e., corresponding to) the normal write energy NE.

The storage controller may sequentially perform the PLP write for the word lines WL2, WL3, WL6, WL10, WL11, and WL14 having (i.e., corresponding to) the low write energy LE and the determined word lines WL1 and WL4 having (i.e., corresponding to) the normal write energy NE. An embodiment in which the storage controller sequentially performs the PLP write from a low word line number is illustrated in FIG. 17. However, in another embodiment, the storage controller may perform the PLP write in a reverse order from a high word line number.

Compared to FIG. 15, in FIG. 17, because the PLP write is sequentially performed from a low word line number (or in a reverse order), the efficiency of program may increase.

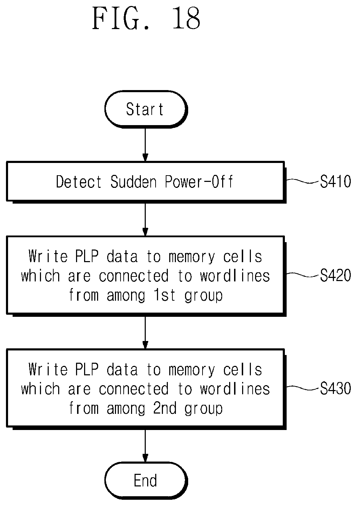

FIG. 18 is a flowchart illustrating an operating method of the storage device 1000 according to an embodiment.

Above, the description is given as the PLP write operation is performed based on the condition that memory cells (or word lines) have one of the low write energy LE or the normal write energy NE. However, in the description of FIG. 18, the description will be given as a range of low write energy is subdivided such that memory cells having (i.e., corresponding to) the low write energy LE are classified into a plurality of groups.

Referring to FIGS. 1, 2, and 18 together, in operation S410, the storage controller 1100 may detect sudden power-off. When the sudden power-off occurs, the storage controller 1100 may store data (i.e., PLP data) being processed (i.e., data stored in the buffer or the internal buffer 1120) in the PLP area 1210a.

In operation S420, the storage controller 1100 may write the PLP data in memory cells connected to word lines of a first group. Herein, the memory cells connected to the word lines of the first group may have write energy (hereinafter referred to as "first low write energy LE1") of the lowest range.

In operation S430, the storage controller 1100 may write the PLP data in memory cells connected to word lines of a second group. Herein, the memory cells connected to the word lines of the second group may have write energy (hereinafter referred to as "second low write energy LE2") of the second lowest range. Herein, a value of the first low write energy LE1 may always be less than a value of the second low write energy LE2.

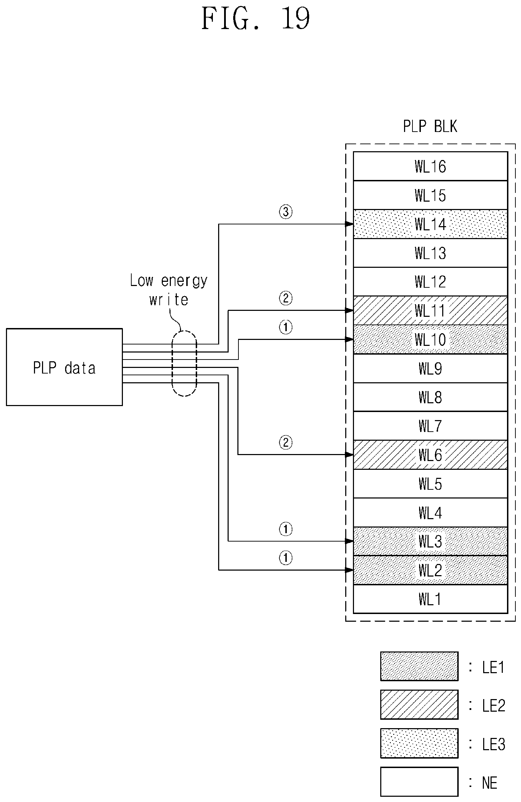

FIG. 19 illustrates an example of PLP write according to the method described with reference to FIG. 18.

Referring to FIG. 19, word lines of a PLP block may be divided into word lines WL2, WL3, and WL10 having (i.e., corresponding to) the first low write energy LE1, word lines WL6 and WL11 having (i.e., corresponding to) the second low write energy LE2, a word line WL14 having third low write energy LE3, and word lines WL1, WL4, WL5, WL7, WL8, WL9, WL12, WL13, WL15, and WL16 having (i.e., corresponding to) the normal write energy NE.

According to the operating method described with reference to FIG. 18, the storage controller may detect the sudden power-off and may perform the PLP write for the word lines WL2, WL3, and WL10 having (i.e., corresponding to) the first low write energy LE1. When the size of memory cells connected to the word lines WL2, WL3, and WL10 having (i.e., corresponding to) the first low write energy LE1 is greater than or equal to the size of PLP data, the PLP write may be terminated.

However, when the size of memory cells connected to the word lines WL2, WL3, and WL10 having (i.e., corresponding to) the first low write energy LE1 is less than the size of the PLP data, the storage controller is able to perform the PLP write for the word lines WL6 and WL11 having (i.e., corresponding to) the second low write energy LE2. When the size of memory cells connected to the word lines WL6 and WL11 having (i.e., corresponding to) the second low write energy LE2 is greater than or equal to the size of the remaining PLP data, the PLP write may be terminated.

However, when the size of memory cells connected to the word lines WL6 and WL11 having (i.e., corresponding to) the second low write energy LE2 is less than the size of the remaining PLP data, the storage controller is able to perform the PLP write for the word line WL14 having third low write energy LE3. When the size of memory cells connected to the word line WL14 having third low write energy LE3 is greater than or equal to the size of the remaining PLP data, the PLP write may be terminated.

In contrast, when the size of the memory cells connected to the word line WL14 having third low write energy LE3 is less than the size of the remaining PLP data, the storage controller is able to perform the PLP write for the word lines WL1, WL4, WL5, WL7, WL8, WL9, WL12, WL13, WL15, and WL16 having (i.e., corresponding to) the normal write energy NE.

In FIG. 19, because the PLP write is performed in order from a word line having (i.e., corresponding to) the first low write energy LE1 to a word line having (i.e., corresponding to) the third low write energy LE3, the PLP write may not be performed sequentially (or in a reverse order) depending on word line numbers. However, in another embodiment, the PLP write may be performed depending on word line number (or in a reverse order) by applying the PLP write method with reference to FIGS. 16 and 17.

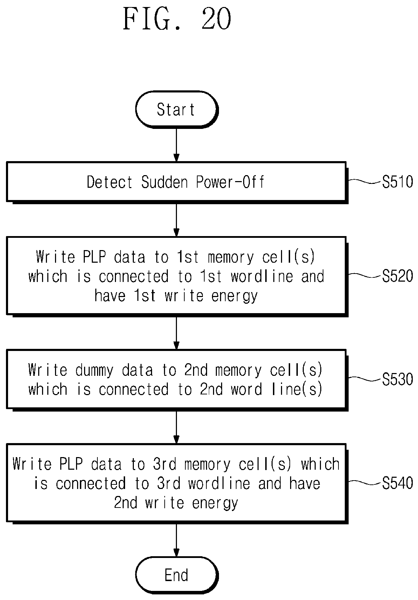

FIG. 20 is a flowchart illustrating an operating method of the storage device 1000 according to an embodiment.

Referring to FIGS. 1, 2, and 20 together, in operation S510, the storage controller 1100 may detect sudden power-off. When the sudden power-off occurs, the storage controller 1100 may store data (i.e., PLP data) being processed (i.e., data stored in the buffer or the internal buffer 1120) in the PLP area 1210a.

In operation S520, the storage controller 1100 may write the PLP data in a first memory cell having first write energy and connected to a first word line. Alternatively, the storage controller 1100 may write the PLP data in memory cells having (i.e., corresponding to) the first write energy and connected to the first word line.

In operation S530, the storage controller 1100 may write dummy data in a second memory cell having connected to a second word line adjacent to the first word line. In an embodiment, dummy programming for a memory cell in which PLP data are not written may be performed to prevent the degradation of a memory cell in which PLP data are stored and to manage the lifetime of the PLP block.

In operation S540, the storage controller 1100 may write the PLP data in a third memory cell having second write energy and connected to a third word line. Alternatively, the storage controller 1100 may write the PLP data in memory cells having (i.e., corresponding to) the second write energy and connected to the third word line. Herein, the third word line may be a word line which is adjacent to the second word line but is not adjacent to the first word line.

In FIG. 20, the description is given as two word lines where the PLP data are written are disposed in a state where one word line where dummy data are written is interposed therebetween, but embodiments are not limited thereto. That is, in another embodiment, a plurality of word lines where dummy data are written may be disposed between two word lines where the PLP data are written.

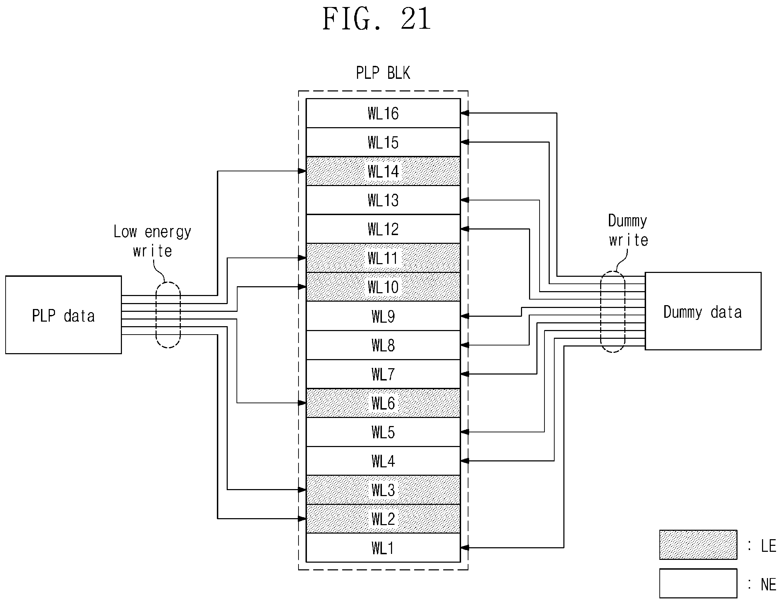

FIG. 21 illustrates an example of PLP write according to the method described with reference to FIG. 20.

Referring to FIG. 21, word lines of a PLP block may be divided into word lines WL2, WL3, WL6, WL10, WL11, and WL14 having (i.e., corresponding to) the low write energy LE and word lines WL1, WL4, WL5, WL7, WL8, WL9, WL12, WL13, WL15, and WL16 having (i.e., corresponding to) the normal write energy NE.

The storage controller may detect the sudden power-off and may perform the PLP write and the dummy write in one direction, for example, in a direction in which a word line number increases or decreases.

In an embodiment, the storage controller may perform the dummy write for memory cells connected to the first word line WL1 and may perform the PLP write for the second word line WL2 and the third word line WL3. In succession, the storage controller may alternately perform the dummy write and the PLP write as illustrated in FIG. 21.

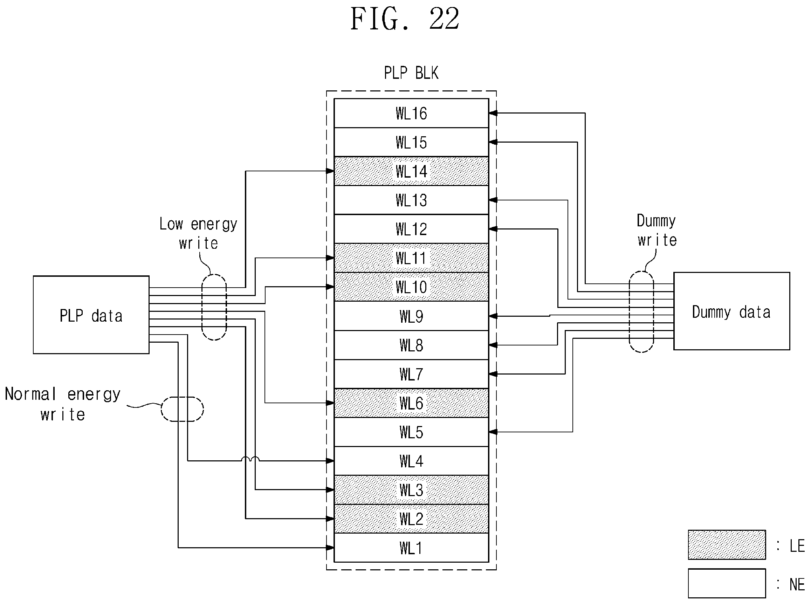

FIG. 22 illustrates another embodiment of PLP write according to the method described with reference to FIG. 20.

Referring to FIG. 22, word lines of a PLP block may be divided into the word lines WL2, WL3, WL6, WL10, WL11, and WL14 having (i.e., corresponding to) the low write energy LE and the word lines WL1, WL4, WL5, WL7, WL8, WL9, WL12, WL13, WL15, and WL16 having (i.e., corresponding to) the normal write energy NE.

The storage controller may detect the sudden power-off and may perform the PLP write and the dummy write in one direction, for example, in a direction in which a word line number increases or decreases. However, unlike FIG. 21, in FIG. 22, the size of the PLP data may be greater than the size of memory cells having (i.e., corresponding to) the low write energy LE. Accordingly, a portion of the PLP data may be written in memory cells having (i.e., corresponding to) the normal write energy NE.

In an embodiment, the storage controller may perform the normal write energy PLP write for memory cells connected to the first word line WL1 and may perform the low energy PLP write for the second word line WL2 and the third word line WL3. Also, the storage controller may perform the normal write energy PLP write for the fourth word line WL4 and may perform the dummy write for the fifth word line WL5.

In succession, the storage controller may alternately perform the low energy PLP write and the dummy write as illustrated in FIG. 22.

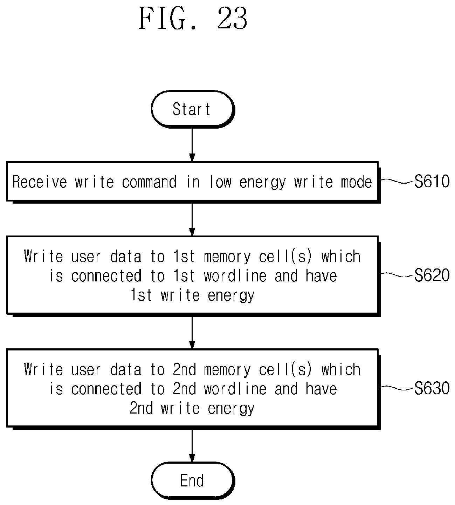

FIG. 23 is a flowchart illustrating an operating method of the storage device 1000 according to an embodiment. Various methods of storing the PLP data in the PLP block of the nonvolatile memory device when the sudden power-off occurs are described above. However, a scheme to preferentially perform the program operation for a memory cell (or memory cells connected to a word line) having (i.e., corresponding to) low write energy based on a value of the write energy may be applied to store the user data without modification.

Referring to FIGS. 1, 2, and 23 together, in operation S610, in the low energy write mode, the nonvolatile memory device 1200 may receive the write command from the storage controller 1100. Herein, the write command may be a normal write command or may be a separate command (e.g., a vendor-specific command) for executing a low energy write operation.

In operation S620, the storage controller 1100 may write the user data in at least one first memory cell having first write energy and connected to a first word line.

In operation S630, the storage controller 1100 may write the user data in at least one second memory cell having second write energy and connected to a second word line. Herein, energy required to program the first memory cell may be less than energy required to program the second memory cell.

In an embodiment, depending on settings of the user or when a given condition is satisfied, the storage device 1000 may enter the low energy write mode. For example, when the size of write data requested by the user is less than the size of one memory block (or is less than the size of a programmable space of one block), the storage device 1000 may enter the low energy write mode. A storage controller may write the user data in memory cells of a specific memory block, which have (i.e., correspond to) the low write energy LE, and for the stability of data, the prevention of degradation of a memory cell, and/or the management of lifetime of a memory block, the storage controller may allow a memory block to be left alone in an open block state without programming an empty space any more or may program dummy data in the empty space.

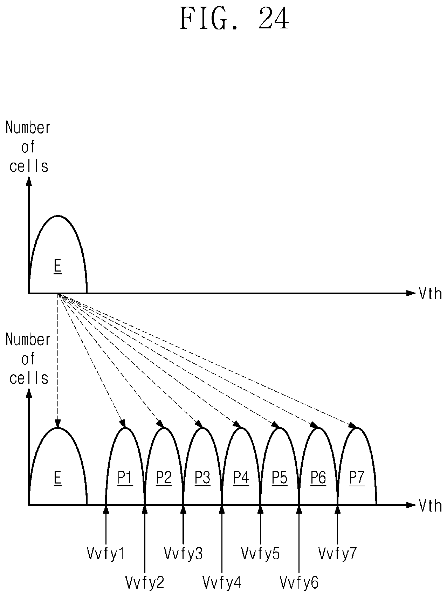

FIG. 24 is a diagram illustrating threshold voltage distributions of memory cells of the normal area 1210b of FIG. 7. In the distribution diagram of FIG. 24, the horizontal axis represents a threshold voltage of a memory cell, and the vertical axis represents the number of memory cells.

In an embodiment, for convenience of description, it is assumed that each of memory cells of the normal area 1210b is a TLC configured to store three bits per memory cell. However, embodiments are not limited thereto. For example, each of the memory cells may be implemented in the form of a single level cell (SLC), a multi-level cell (MLC), or a quadruple level cell (QLC).

Referring to FIGS. 3 and 24, the nonvolatile memory device 1200 may store data in memory cells of the memory block BLK by controlling threshold voltages of the memory cells. For example, each of the memory cells may be programmed to have one of the erase state "E" and a plurality of program states P1 to P7.

The nonvolatile memory device 1200 may verify states of the memory cells by using a plurality of verify voltages Vvfy1 to Vvfy7. For example, the nonvolatile memory device 1200 may verify whether memory cells corresponding to the first program state P1 are normally programmed, by using the first verify voltage Vvfy1. The nonvolatile memory device 1200 may verify whether memory cells corresponding to the second program state P2 are normally programmed, by using the second verify voltage Vvfy2. Likewise, the nonvolatile memory device 1200 may verify whether memory cells corresponding to the third to seventh program states P3 to P7 are normally programmed, by using the third to seventh verify voltages Vvfy 3 to Vvfy7.

The nonvolatile memory device 1200 may determine data stored in the memory cells by sensing program states (i.e., threshold voltages) of the memory cells.

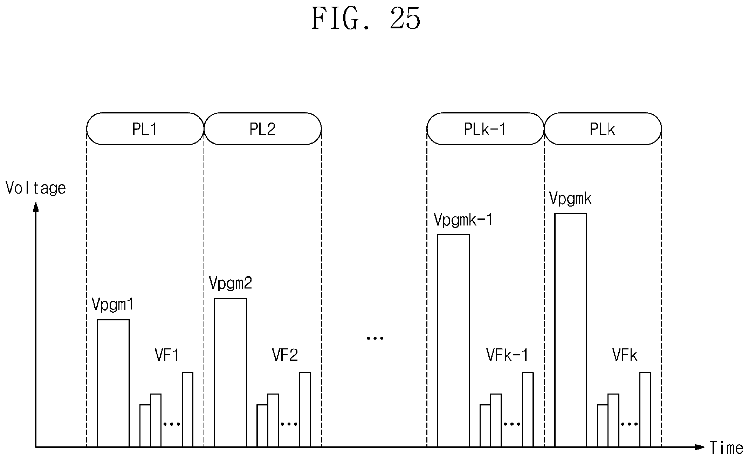

FIG. 25 is a diagram for describing a program operation for memory cells of the normal area 1210b of FIG. 1. The program operation to be described in an embodiment of FIG. 25 may be associated with determining a program characteristic (i.e., the low write energy LE or the normal write energy NE) for each word line in a test phase of the nonvolatile memory device 1200.

In an embodiment, the nonvolatile memory device 1200 may program memory cells of the normal area 1210b by sequentially performing a plurality of program loops based on the ISPP manner.

Referring to FIG. 25, the nonvolatile memory device 1200 may perform the program operation through a plurality of program loops PL1 to PLk. Each of the plurality of program loops PL1 to PLk may include a program phase and a verify phase. The program phase may include applying a program voltage (e.g., each of Vpgm1 to Vpgmk) to a selected word line. The verify phase may include applying a set of verify voltages (e.g., verify voltages of VF1 to VFk) to the selected word line. In an embodiment, the verify voltage set of each verify phase may include at least some of the plurality of verify voltages Vvfy1 to Vvfy7 described with reference to FIG. 24.

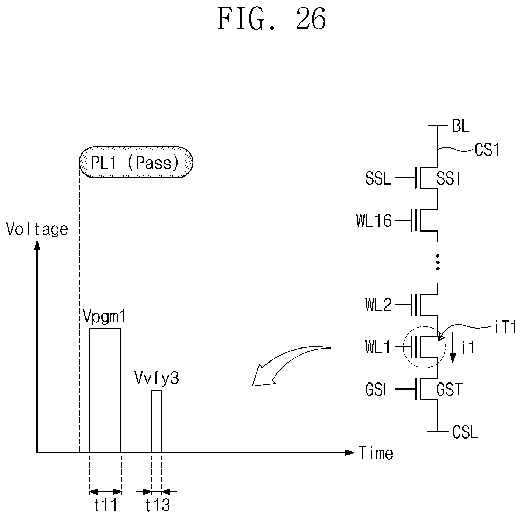

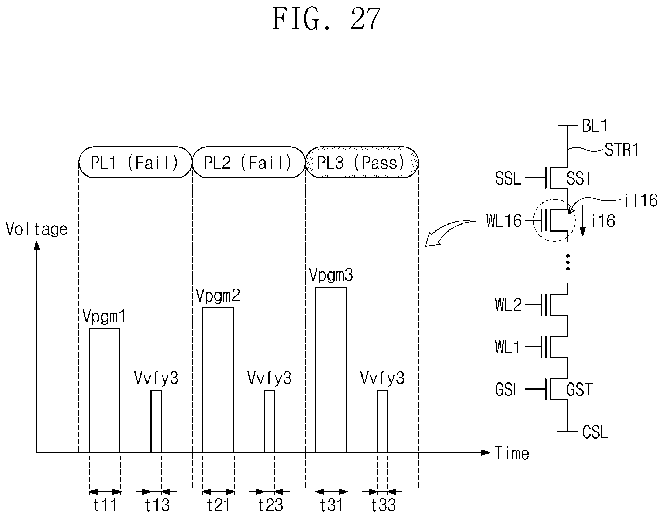

FIG. 26 conceptually illustrates a program operation performed for a specific memory cell of the normal area 1210b (refer to FIG. 1). FIG. 27 conceptually illustrates a program operation performed for a specific memory cell of the normal area 1210b (refer to FIG. 1).

A method of determining a program characteristic of a memory cell of a normal area will be described with reference to FIGS. 26 and 27 and is mostly similar to that described with reference to FIGS. 10 and 11. Therefore, below, the description will be briefly given, or the same description as given above may be omitted.

In an embodiment, when the program operation is performed based on the ISPP manner such that the memory cell is programmed to the third program state P3, the electrical energy which is required when the memory cell is program-passed only in one program loop PL1 (refer to FIG. 26) may be less than the electrical energy which is required when the memory cell is program-passed after three program loops PL1 to PL3 are executed (refer to FIG. 27). Accordingly, the memory cell connected to the first word line WL1 of FIG. 26 may be determined as having (i.e., corresponding to) the low write energy LE, and the memory cell connected to the sixteenth word line WL16 of FIG. 27 may be determined as having (i.e., corresponding to) the normal write energy NE.

In an embodiment, the memory cell (refer to FIG. 26) program-passed only in one program loop PL1 may be determined as having (i.e., corresponding to) the low write energy LE, and the memory cell (refer to FIG. 27) program-passed after a relatively great number of program loops PL1 to PL3 are executed may be determined as having (i.e., corresponding to) the normal write energy NE.

Additionally/alternatively, to determine a program characteristic of a memory cell, the level of the program voltage Vpgm, whether to skip the verify operation, the intensity of a tunneling current of a memory cell, a duration time of the program voltage Vpgm, etc., may be considered independently of each other or in a combination, and one skilled in the art may determine whether a memory cell of the normal area 1210b has the low write energy LE or the normal write energy NE, based on a combination of the above factors.

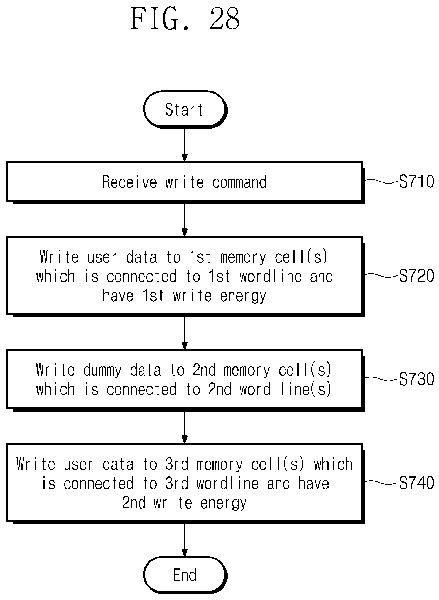

FIG. 28 is a flowchart illustrating an operating method of the storage device 1000 according to an embodiment. FIG. 28 is similar to FIG. 20, in which the PLP data and the dummy data are written in the PLP area. Therefore, the description will be briefly given.

Referring to FIGS. 1, 2, and 28 together, in operation S710, in the low energy write mode, the nonvolatile memory device 1200 may receive the write command from the storage controller 1100. Herein, the write command may be a normal write command or may be a vendor-specific command for executing the low energy write operation.

The storage controller 1100 may write the user data in at least one first memory cell having first write energy and connected to a first word line (S720). The storage controller 1100 may write the dummy data in a second memory cell connected to a second word line. Herein, the second word line may be a word line which is adjacent to the first word line. The storage controller 1100 may write the user data in at least one third memory cell having second write energy and connected to a third word line (S740). Herein, the third word line may be a word line which is adjacent to the second word line but is not adjacent to the first word line.

In FIG. 28, the description is given as two word lines where the user data are written are disposed in a state where one word line where the dummy data are written is interposed therebetween, but embodiments are not limited thereto. That is, in another embodiment, a plurality of word lines where the dummy data are written may be disposed between two word lines where the user data are written.

In addition, a method of performing low energy write when the size of user data is greater than the size of the memory block may be performed to be similar to the method described with reference to FIG. 14. Also, a method of performing low energy write in order of word line numbers may be performed to be similar to the method described with reference to FIG. 16. In addition, a method of subdividing a range of the low write energy, classifying memory cells having (i.e., corresponding to) the low write energy LE, and performing low energy write may be performed to be similar to the method described with reference to FIG. 19.

Methods of writing the PLP data in the PLP area based on write energy when the sudden power-off occurs and the method of writing the user data in the normal area based on write energy are described above. According to embodiments, it may be possible to efficiently use the limited energy of the super capacitor when the sudden power-off occurs, and also, it may be possible to reduce a PLP write time. In addition, in the normal write operation, it may be possible to reduce the write energy under a specific condition, and also, it may be possible to reduce a write time (e.g., tPROG)

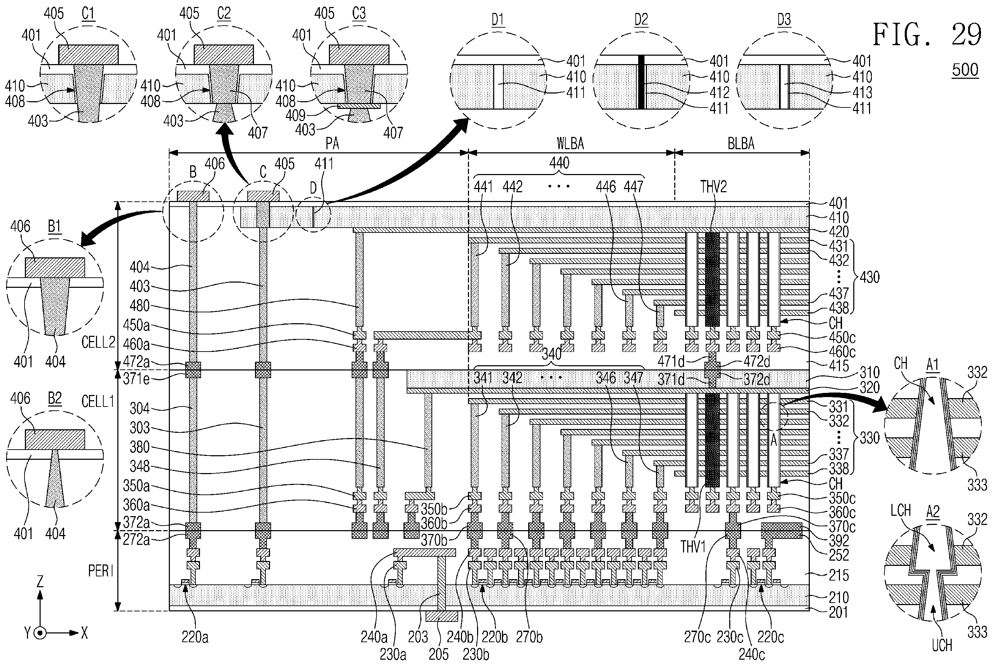

FIG. 29 is a view illustrating a memory device 500 according to some embodiments.

Referring to FIG. 29, the memory device 500 may have a chip-to-chip (C2C) structure. At least one upper chip including a cell region and a lower chip including a peripheral circuit region PERI may be manufactured separately, and then, the at least one upper chip and the lower chip may be connected to each other by a bonding method to realize the C2C structure. For example, the bonding method may indicate a method of electrically or physically connecting a bonding metal pattern formed in an uppermost metal layer of the upper chip to a bonding metal pattern formed in an uppermost metal layer of the lower chip. For example, in a case in which the bonding metal patterns are formed of copper (Cu), the bonding method may be a Cu-Cu bonding method. Alternatively, the bonding metal patterns may be formed of aluminum (Al) or tungsten (W).

The memory device 500 may include the at least one upper chip including the cell region. For example, as illustrated in FIG. 29, the memory device 500 may include two upper chips. However, the number of the upper chips is not limited thereto. In the case in which the memory device 500 includes the two upper chips, a first upper chip including a first cell region CELL1, a second upper chip including a second cell region CELL2 and the lower chip including the peripheral circuit region PERI may be manufactured separately, and then, the first upper chip, the second upper chip and the lower chip may be connected to each other by the bonding method to manufacture the memory device 500. The first upper chip may be turned over and then may be connected to the lower chip by the bonding method, and the second upper chip may also be turned over and then may be connected to the first upper chip by the bonding method. Hereinafter, upper and lower portions of each of the first and second upper chips will be defined based on before each of the first and second upper chips is turned over. In this regard, an upper portion of the lower chip may indicate an upper portion defined based on a +Z-axis direction, and the upper portion of each of the first and second upper chips may indicate an upper portion defined based on a -Z-axis direction in FIG. 29. However, embodiments are not limited thereto. In certain embodiments, one of the first upper chip and the second upper chip may be turned over and then may be connected to a corresponding chip by the bonding method.

Each of the peripheral circuit region PERI and the first and second cell regions CELL1 and CELL2 of the memory device 500 may include an external pad bonding region PA, a word line bonding region WLBA, and a bit line bonding region BLBA.

The peripheral circuit region PERI may include a first substrate 210 and a plurality of circuit elements 220a, 220b and 220c formed on the first substrate 210. An interlayer insulating layer 215 including one or more insulating layers may be provided on the plurality of circuit elements 220a, 220b and 220c, and a plurality of metal lines electrically connected to the plurality of circuit elements 220a, 220b and 220c may be provided in the interlayer insulating layer 215. For example, the plurality of metal lines may include first metal lines 230a, 230b and 230c connected to the plurality of circuit elements 220a, 220b and 220c, and second metal lines 240a, 240b and 240c formed on the first metal lines 230a, 230b and 230c. The plurality of metal lines may be formed of at least one of various conductive materials. For example, the first metal lines 230a, 230b and 230c may be formed of tungsten having a relatively high electrical resistivity, and the second metal lines 240a, 240b and 240c may be formed of copper having a relatively low electrical resistivity.

The first metal lines 230a, 230b and 230c and the second metal lines 240a, 240b and 240c are illustrated and described in the present embodiments. However, embodiments are not limited thereto. In certain embodiments, at least one or more additional metal lines may further be formed on the second metal lines 240a, 240b and 240c. In this case, the second metal lines 240a, 240b and 240c may be formed of aluminum, and at least some of the additional metal lines formed on the second metal lines 240a, 240b and 240c may be formed of copper having an electrical resistivity lower than that of aluminum of the second metal lines 240a, 240b and 240c.

The interlayer insulating layer 215 may be disposed on the first substrate 210 and may include an insulating material such as silicon oxide and/or silicon nitride.

Each of the first and second cell regions CELL1 and CELL2 may include at least one memory block. The first cell region CELL1 may include a second substrate 310 and a common source line 320. A plurality of word lines 330 (331 to 338) may be stacked on the second substrate 310 in a direction (i.e., the Z-axis direction) perpendicular to a top surface of the second substrate 310. String selection lines and a ground selection line may be disposed on and under the word lines 330, and the plurality of word lines 330 may be disposed between the string selection lines and the ground selection line. Likewise, the second cell region CELL2 may include a third substrate 410 and a common source line 420, and a plurality of word lines 430 (431 to 438) may be stacked on the third substrate 410 in a direction (i.e., the Z-axis direction) perpendicular to a top surface of the third substrate 410. Each of the second substrate 310 and the third substrate 410 may be formed of at least one of various materials and may be, for example, a silicon substrate, a silicon-germanium substrate, a germanium substrate, or a substrate having a single-crystalline epitaxial layer grown on a single-crystalline silicon substrate. A plurality of channel structures CH may be formed in each of the first and second cell regions CELL1 and CELL2.

In some embodiments, as illustrated in a region 'A1', the channel structure CH may be provided in the bit line bonding region BLBA and may extend in the direction perpendicular to the top surface of the second substrate 310 to penetrate the word lines 330, the string selection lines, and the ground selection line. The channel structure CH may include a data storage layer, a channel layer, and a filling insulation layer. The channel layer may be electrically connected to a first metal line 350c and a second metal line 360c in the bit line bonding region BLBA. For example, the second metal line 360c may be a bit line and may be connected to the channel structure CH through the first metal line 350c. The bit line 360c may extend in a first direction (e.g., a Y-axis direction) parallel to the top surface of the second substrate 310.

In some embodiments, as illustrated in a region 'A2', the channel structure CH may include a lower channel LCH and an upper channel UCH, which are connected to each other. For example, the channel structure CH may be formed by a process of forming the lower channel LCH and a process of forming the upper channel UCH. The lower channel LCH may extend in the direction perpendicular to the top surface of the second substrate 310 to penetrate the common source line 320 and lower word lines 331 and 332. The lower channel LCH may include a data storage layer, a channel layer, and a filling insulation layer and may be connected to the upper channel UCH. The upper channel UCH may penetrate upper word lines 333 to 338. The upper channel UCH may include a data storage layer, a channel layer, and a filling insulation layer, and the channel layer of the upper channel UCH may be electrically connected to the first metal line 350c and the second metal line 360c. As a length of a channel increases, due to characteristics of manufacturing processes, it may be difficult to form a channel having a substantially uniform width. The memory device 500 according to the present embodiments may include a channel having improved width uniformity due to the lower channel LCH and the upper channel UCH which are formed by the processes performed sequentially.

In the case in which the channel structure CH includes the lower channel LCH and the upper channel UCH as illustrated in the region 'A2', a word line located near to a boundary between the lower channel LCH and the upper channel UCH may be a dummy word line. For example, the word lines 332 and 333 adjacent to the boundary between the lower channel LCH and the upper channel UCH may be the dummy word lines. In this case, data may not be stored in memory cells connected to the dummy word line. Alternatively, the number of pages corresponding to the memory cells connected to the dummy word line may be less than the number of pages corresponding to the memory cells connected to a general word line. A level of a voltage applied to the dummy word line may be different from a level of a voltage applied to the general word line, and thus it is possible to reduce an influence of a non-uniform channel width between the lower and upper channels LCH and UCH on an operation of the memory device.

The number of the lower word lines 331 and 332 penetrated by the lower channel LCH is less than the number of the upper word lines 333 to 338 penetrated by the upper channel UCH in the region 'A2'. However, embodiments are not limited thereto. In certain embodiments, the number of the lower word lines penetrated by the lower channel LCH may be equal to or more than the number of the upper word lines penetrated by the upper channel UCH. In addition, structural features and connection relation of the channel structure CH disposed in the second cell region CELL2 may be substantially the same as those of the channel structure CH disposed in the first cell region CELL1.

In the bit line bonding region BLBA, a first through-electrode THV1 may be provided in the first cell region CELL1, and a second through-electrode THV2 may be provided in the second cell region CELL2. As illustrated in FIG. 29, the first through-electrode THV1 may penetrate the common source line 320 and the plurality of word lines 330. In certain embodiments, the first through-electrode THV1 may further penetrate the second substrate 310. The first through-electrode THV1 may include a conductive material. Alternatively, the first through-electrode THV1 may include a conductive material surrounded by an insulating material. The second through-electrode THV2 may have the same shape and structure as the first through-electrode THV1.

In some embodiments, the first through-electrode THV1 and the second through-electrode THV2 may be electrically connected to each other through a first through-metal pattern 372d and a second through-metal pattern 472d. The first through-metal pattern 372d may be formed at a bottom end of the first upper chip including the first cell region CELL1, and the second through-metal pattern 472d may be formed at a top end of the second upper chip including the second cell region CELL2. The first through-electrode THV1 may be electrically connected to the first metal line 350c and the second metal line 360c. A lower via 371d may be formed between the first through-electrode THV1 and the first through-metal pattern 372d, and an upper via 471d may be formed between the second through-electrode THV2 and the second through-metal pattern 472d. The first through-metal pattern 372d and the second through-metal pattern 472d may be connected to each other by the bonding method.

In addition, in the bit line bonding region BLBA, an upper metal pattern 252 may be formed in an uppermost metal layer of the peripheral circuit region PERI, and an upper metal pattern 392 having the same shape as the upper metal pattern 252 may be formed in an uppermost metal layer of the first cell region CELL1. The upper metal pattern 392 of the first cell region CELL1 and the upper metal pattern 252 of the peripheral circuit region PERI may be electrically connected to each other by the bonding method. In the bit line bonding region BLBA, the bit line 360c may be electrically connected to a page buffer included in the peripheral circuit region PERI. For example, some of the circuit elements 220c of the peripheral circuit region PERI may constitute the page buffer, and the bit line 360c may be electrically connected to the circuit elements 220c constituting the page buffer through an upper bonding metal pattern 370c of the first cell region CELL1 and an upper bonding metal pattern 270c of the peripheral circuit region PERI.

Referring continuously to FIG. 29, in the word line bonding region WLBA, the word lines 330 of the first cell region CELL1 may extend in a second direction (e.g., an X-axis direction) parallel to the top surface of the second substrate 310 and may be connected to a plurality of cell contact plugs 340 (341 to 347). First metal lines 350b and second metal lines 360b may be sequentially connected onto the cell contact plugs 340 connected to the word lines 330. In the word line bonding region WLBA, the cell contact plugs 340 may be connected to the peripheral circuit region PERI through upper bonding metal patterns 370b of the first cell region CELL1 and upper bonding metal patterns 270b of the peripheral circuit region PERI.

The cell contact plugs 340 may be electrically connected to a row decoder included in the peripheral circuit region PERI. For example, some of the circuit elements 220b of the peripheral circuit region PERI may constitute the row decoder, and the cell contact plugs 340 may be electrically connected to the circuit elements 220b constituting the row decoder through the upper bonding metal patterns 370b of the first cell region CELL1 and the upper bonding metal patterns 270b of the peripheral circuit region PERI. In some embodiments, an operating voltage of the circuit elements 220b constituting the row decoder may be different from an operating voltage of the circuit elements 220c constituting the page buffer. For example, the operating voltage of the circuit elements 220c constituting the page buffer may be greater than the operating voltage of the circuit elements 220b constituting the row decoder.

Likewise, in the word line bonding region WLBA, the word lines 430 of the second cell region CELL2 may extend in the second direction (e.g., the X-axis direction) parallel to the top surface of the third substrate 410 and may be connected to a plurality of cell contact plugs 440 (441 to 447). The cell contact plugs 440 may be connected to the peripheral circuit region PERI through an upper metal pattern of the second cell region CELL2 and lower and upper metal patterns and a cell contact plug 348 of the first cell region CELL1.

In the word line bonding region WLBA, the upper bonding metal patterns 370b may be formed in the first cell region CELL1, and the upper bonding metal patterns 270b may be formed in the peripheral circuit region PERI. The upper bonding metal patterns 370b of the first cell region CELL1 and the upper bonding metal patterns 270b of the peripheral circuit region PERI may be electrically connected to each other by the bonding method. The upper bonding metal patterns 370b and the upper bonding metal patterns 270b may be formed of aluminum, copper, or tungsten.

In the external pad bonding region PA, a lower metal pattern 371e may be formed in a lower portion of the first cell region CELL1, and an upper metal pattern 472a may be formed in an upper portion of the second cell region CELL2. The lower metal pattern 371e of the first cell region CELL1 and the upper metal pattern 472a of the second cell region CELL2 may be connected to each other by the bonding method in the external pad bonding region PA. Likewise, an upper metal pattern 372a may be formed in an upper portion of the first cell region CELL1, and an upper metal pattern 272a may be formed in an upper portion of the peripheral circuit region PERI. The upper metal pattern 372a of the first cell region CELL1 and the upper metal pattern 272a of the peripheral circuit region PERI may be connected to each other by the bonding method.

Common source line contact plugs 380 and 480 may be disposed in the external pad bonding region PA. The common source line contact plugs 380 and 480 may be formed of a conductive material such as a metal, a metal compound, and/or doped polysilicon. The common source line contact plug 380 of the first cell region CELL1 may be electrically connected to the common source line 320, and the common source line contact plug 480 of the second cell region CELL2 may be electrically connected to the common source line 420. A first metal line 350a and a second metal line 360a may be sequentially stacked on the common source line contact plug 380 of the first cell region CELL1, and a first metal line 450a and a second metal line 460a may be sequentially stacked on the common source line contact plug 480 of the second cell region CELL2.

Input/output pads 205, 405 and 406 may be disposed in the external pad bonding region PA. Referring to FIG. 29, a lower insulating layer 201 may cover a bottom surface of the first substrate 210, and a first input/output pad 205 may be formed on the lower insulating layer 201. The first input/output pad 205 may be connected to at least one of a plurality of the circuit elements 220a disposed in the peripheral circuit region PERI through a first input/output contact plug 203 and may be separated from the first substrate 210 by the lower insulating layer 201. In addition, a side insulating layer may be disposed between the first input/output contact plug 203 and the first substrate 210 to electrically isolate the first input/output contact plug 203 from the first substrate 210.

An upper insulating layer 401 covering a top surface of the third substrate 410 may be formed on the third substrate 410. A second input/output pad 405 and/or a third input/output pad 406 may be disposed on the upper insulating layer 401. The second input/output pad 405 may be connected to at least one of the plurality of circuit elements 220a disposed in the peripheral circuit region PERI through second input/output contact plugs 403 and 303, and the third input/output pad 406 may be connected to at least one of the plurality of circuit elements 220a disposed in the peripheral circuit region PERI through third input/output contact plugs 404 and 304.

In some embodiments, the third substrate 410 may not be disposed in a region in which the input/output contact plug is disposed. For example, as illustrated in a region 'B', the third input/output contact plug 404 may be separated from the third substrate 410 in a direction parallel to the top surface of the third substrate 410 and may penetrate an interlayer insulating layer 415 of the second cell region CELL2 so as to be connected to the third input/output pad 406. In this case, the third input/output contact plug 404 may be formed by at least one of various processes.

In some embodiments, as illustrated in a region 'B1', the third input/output contact plug 404 may extend in a third direction (e.g., the Z-axis direction), and a diameter of the third input/output contact plug 404 may become progressively greater toward the upper insulating layer 401. In this regard, a diameter of the channel structure CH described in the region 'A1' may become progressively less toward the upper insulating layer 401, but the diameter of the third input/output contact plug 404 may become progressively greater toward the upper insulating layer 401. For example, the third input/output contact plug 404 may be formed after the second cell region CELL2 and the first cell region CELL1 are bonded to each other by the bonding method.

In certain embodiments, as illustrated in a region 'B2', the third input/output contact plug 404 may extend in the third direction (e.g., the Z-axis direction), and a diameter of the third input/output contact plug 404 may become progressively less toward the upper insulating layer 401. In this regard, like the channel structure CH, the diameter of the third input/output contact plug 404 may become progressively less toward the upper insulating layer 401. For example, the third input/output contact plug 404 may be formed together with the cell contact plugs 440 before the second cell region CELL2 and the first cell region CELL1 are bonded to each other.

In certain embodiments, the input/output contact plug may overlap with the third substrate 410. For example, as illustrated in a region 'C', the second input/output contact plug 403 may penetrate the interlayer insulating layer 415 of the second cell region CELL2 in the third direction (e.g., the Z-axis direction) and may be electrically connected to the second input/output pad 405 through the third substrate 410. In this case, a connection structure of the second input/output contact plug 403 and the second input/output pad 405 may be realized by various methods.

In some embodiments, as illustrated in a region 'C1', an opening 408 may be formed to penetrate the third substrate 410, and the second input/output contact plug 403 may be connected directly to the second input/output pad 405 through the opening 408 formed in the third substrate 410. In this case, as illustrated in the region 'C1', a diameter of the second input/output contact plug 403 may become progressively greater toward the second input/output pad 405. However, embodiments are not limited thereto, and in certain embodiments, the diameter of the second input/output contact plug 403 may become progressively less toward the second input/output pad 405.

In certain embodiments, as illustrated in a region 'C2', the opening 408 penetrating the third substrate 410 may be formed, and a contact 407 may be formed in the opening 408. An end of the contact 407 may be connected to the second input/output pad 405, and another end of the contact 407 may be connected to the second input/output contact plug 403. Thus, the second input/output contact plug 403 may be electrically connected to the second input/output pad 405 through the contact 407 in the opening 408. In this case, as illustrated in the region 'C2', a diameter of the contact 407 may become progressively greater toward the second input/output pad 405, and a diameter of the second input/output contact plug 403 may become progressively less toward the second input/output pad 405. For example, the second input/output contact plug 403 may be formed together with the cell contact plugs 440 before the second cell region CELL2 and the first cell region CELL1 are bonded to each other, and the contact 407 may be formed after the second cell region CELL2 and the first cell region CELL1 are bonded to each other.

In certain embodiments illustrated in a region 'C3', a stopper 409 may further be formed on a bottom end of the opening 408 of the third substrate 410, as compared with region 'C2'. The stopper 409 may be a metal line formed in the same layer as the common source line 420. Alternatively, the stopper 409 may be a metal line formed in the same layer as at least one of the word lines 430. The second input/output contact plug 403 may be electrically connected to the second input/output pad 405 through the contact 407 and the stopper 409.

Like the second and third input/output contact plugs 403 and 404 of the second cell region CELL2, a diameter of each of the second and third input/output contact plugs 303 and 304 of the first cell region CELL1 may become progressively less toward the lower metal pattern 371e or may become progressively greater toward the lower metal pattern 371e.

In some embodiments, a slit 411 may be formed in the third substrate 410. For example, the slit 411 may be formed at a certain position of the external pad bonding region PA. For example, as illustrated in a region 'D', the slit 411 may be located between the second input/output pad 405 and the cell contact plugs 440 when viewed in a plan view. Alternatively, the second input/output pad 405 may be located between the slit 411 and the cell contact plugs 440 when viewed in a plan view.

In some embodiments, as illustrated in a region 'D1', the slit 411 may be formed to penetrate the third substrate 410. For example, the slit 411 may be used to prevent the third substrate 410 from being finely cracked when the opening 408 is formed. However, embodiments are not limited thereto, and in certain embodiments, the slit 411 may be formed to have a depth ranging from about 60% to about 70% of a thickness of the third substrate 410.

In certain embodiments, as illustrated in a region 'D2', a conductive material 412 may be formed in the slit 411. For example, the conductive material 412 may be used to discharge a leakage current occurring in driving of the circuit elements in the external pad bonding region PA to the outside. In this case, the conductive material 412 may be connected to an external ground line.

In certain embodiments, as illustrated in a region 'D3', an insulating material 413 may be formed in the slit 411. For example, the insulating material 413 may be used to electrically isolate the second input/output pad 405 and the second input/output contact plug 403 disposed in the external pad bonding region PA from the word line bonding region WLBA. Because the insulating material 413 is formed in the slit 411, it is possible to prevent a voltage provided through the second input/output pad 405 from affecting a metal layer disposed on the third substrate 410 in the word line bonding region WLBA.

In certain embodiments, the first to third input/output pads 205, 405 and 406 may be selectively formed. For example, the memory device 500 may be realized to include only the first input/output pad 205 disposed on the first substrate 210, to include only the second input/output pad 405 disposed on the third substrate 410, or to include only the third input/output pad 406 disposed on the upper insulating layer 401.

In some embodiments, at least one of the second substrate 310 of the first cell region CELL1 or the third substrate 410 of the second cell region CELL2 may be used as a sacrificial substrate and may be completely or partially removed before or after a bonding process. An additional layer may be stacked after the removal of the substrate. For example, the second substrate 310 of the first cell region CELL1 may be removed before or after the bonding process of the peripheral circuit region PERI and the first cell region CELL1, and then, an insulating layer covering a top surface of the common source line 320 or a conductive layer for connection may be formed. Likewise, the third substrate 410 of the second cell region CELL2 may be removed before or after the bonding process of the first cell region CELL1 and the second cell region CELL2, and then, the upper insulating layer 401 covering a top surface of the common source line 420 or a conductive layer for connection may be formed.

According to embodiments, when sudden power-off occurs, PLP data being processed may be efficiently written based on write energy.

According to embodiments, user data may be efficiently written based on write energy.

While aspects of embodiments have been described, it will be apparent to those of ordinary skill in the art that various changes and modifications may be made thereto without departing from the spirit and scope of the present disclosure as set forth in the following claims.

## Claims

1. A storage device comprising:

   a nonvolatile memory device comprising a memory cell array, the memory cell array comprising a user area and a power loss protection (PLP) area; and
   a storage controller configured to, based on sudden power-off being detected, write first PLP data in a first memory cell connected to a first word line of the PLP area and write second PLP data in a second memory cell connected to a second word line of the PLP area,
   wherein a first write energy of the first memory cell is less than a second write energy of the second memory cell.

2. The storage device of claim 1, wherein the first write energy corresponds to a first program voltage used to write the first PLP data in the first memory cell, a first tunneling current used to write the first PLP data in the first memory cell, and a time during which the first program voltage is applied to write the first PLP data in the first memory cell, and wherein the second write energy corresponds to a second program voltage used to write the second PLP data in the second memory cell, a second tunneling current used to write the second PLP data in the second memory cell, and a time during which the second program voltage is applied to write the second PLP data in the second memory cell.

3. The storage device of claim 1, wherein a first level of a first program voltage used to write the first PLP data in the first memory cell is lower than a second level of a second program voltage used to write the second PLP data in the second memory cell.

4. The storage device of claim 1, wherein a number of first program loops executed to write the first PLP data in the first memory cell is less than a number of second program loops executed to write the second PLP data in the second memory cell.

5. The storage device of claim 1, wherein a first time during which a first program voltage is applied to write the first PLP data in the first memory cell is shorter than a second time during which a second program voltage is applied to write the second PLP data in the second memory cell.

6. The storage device of claim 1, wherein the storage controller is further configured to:

   based on the first PLP data being written in the first memory cell, not apply a verify voltage for verifying whether the first memory cell is program-passed to the first memory cell; and
   based on the second PLP data being written in the second memory cell, apply a verify voltage for verifying whether the second memory cell is program-passed to the second memory cell at least once.

7. The storage device of claim 1, wherein a channel hole corresponding to the first memory cell is smaller than a channel hole corresponding to the second memory cell.

8. The storage device of claim 1, wherein a third word line is provided between the first word line connected to the first memory cell and the second word line connected to the second memory cell.

9. The storage device of claim 8, wherein the storage controller is further configured to, after the writing the first PLP data in the first memory cell and before writing the second PLP data in the second memory cell, write dummy data in a third memory cell connected to the third word line.

10. The storage device of claim 1, wherein the storage controller is further configured to, after the sudden power-off is terminated, read the first PLP data and the second PLP data stored in the PLP area, and complete processing for the first PLP data and the second PLP data.

11. A storage device comprising:

a nonvolatile memory device comprising a memory cell array, the memory cell array comprising a user area and a power loss protection (PLP) area; and
a storage controller configured to, based on sudden power-off being detected, write first PLP data in a first memory cell connected to a first word line, write dummy data in a second memory cell connected to a second word line of the PLP area, and write second PLP data in a third memory cell connected to a third word line of the PLP area, which is adjacent to the second word line, and having second write energy,
wherein the second word line is adjacent each of the first word line and the third word line, and
wherein a first write energy of the first memory cell is less than a second write energy of the second memory cell.

12. The storage device of claim 11, wherein the first write energy corresponds to a first program voltage used to write the first PLP data in the first memory cell, a first tunneling current used to write the first PLP data in the first memory cell, and a time during which the first program voltage is applied to write the first PLP data in the first memory cell, and wherein the second write energy corresponds to a second program voltage used to write the second PLP data in the second memory cell, a second tunneling current used to write the second PLP data in the second memory cell, and a time during which the second program voltage is applied to write the second PLP data in the second memory cell.

13. The storage device of claim 11, wherein a first level of a first program voltage used to write the first PLP data in the first memory cell is lower than a second level of a second program voltage used to write the second PLP data in the second memory cell.

14. The storage device of claim 11, wherein a number of first program loops executed to write the first PLP data in the first memory cell is less than a number of second program loops executed to write the second PLP data in the second memory cell.

15. The storage device of claim 11, wherein a first time during which a first program voltage is applied to write the first PLP data in the first memory cell is shorter than a second time during which a second program voltage is applied to write the second PLP data in the second memory cell.

# FIG. 1

# FIG. 2

1100

1110        1120        1130

| Processor(s) | Internal Buffer | ECC |

Bus

1140        1150        1160

100 ← | Host I/F Circuit | Buffer Controller | Memory I/F Circuit | → 1200

Buffer

# FIG. 3

1200

1220                                    1210

Row Decoder (1220)
— SSL —
— WL —
— GSL —

Memory Cell Array (1210):
BLKz
⋮
BLK3
BLK2
BLK1

— BL(s) —

Page Buffer (1230)

— DL(s) —

I/O Circuit (1240)
CA    DATA

Control Logic Circuit (1260)

Buffer Circuit (1250)

RA

CTRL    ADDR    CMD    DATA

# FIG. 4

BLK1

SSL, DWL2, WL1~WL10, DWL1, GSL

BL1, BL2, BL3, BL4

SSLl1, SSLu1, SSLl2, SSLu2, SSLl3, SSLu3, SSLl4, SSLu4, CS

SSTu, SSTl, DMC2, MC1~MC10, DMC1, GST

CSL

SUB

Perpendicular Direction

3rd Direction

2nd Direction

1st Direction

# FIG. 5

BL3

BL2

118
CM15
CM14
CM13
CM12
CM11
CM10
CM9
CM8
CM7
CM6
CM5
CM4
CM3
CM2
CM1

CSR
101
116
114
115
PL

117
112

116
114
115
PL

CSR

3rd
Direction

2nd
Direction

1st
Direction

# FIG. 6

```
        ┌─────────┐
        │  Start  │
        └────┬────┘
             │
             ▼
┌──────────────────────────────┐
│    Detect Sudden Power-Off   │──── S110
└──────────────┬───────────────┘
               │
               ▼
┌──────────────────────────────┐
│ Write PLP data to 1st memory │
│ cell(s) which is connected   │──── S120
│ to 1st wordline and have 1st │
│         write energy         │
└──────────────┬───────────────┘
               │
               ▼
┌──────────────────────────────┐
│ Write PLP data to 2nd memory │
│ cell(s) which is connected   │──── S130
│ to 2nd wordline and have 2nd │
│         write energy         │
└──────────────┬───────────────┘
               │
               ▼
          ┌─────────┐
          │   End   │
          └─────────┘
```

# FIG. 7

② Detect SPO

**Storage Controller** — 1100

Low energy write manager (1170)

① Read WL table for low energy write

**Buffer** — 1300

| | |
|---|---|
| LA1(WL0~11) | NE |
| LA2(WL12~47) | LE |
| LA3(WL48~59) | NE |
| LA4(WL60~84) | LE |
| ⋮ | ⋮ |
| PLP Data | |

1000

1200

**NVM**

\<WL table\>

| | |
|---|---|
| LA1(WL0~11) | NE |
| LA2(WL12~47) | LE |
| LA3(WL48~59) | NE |
| LA4(WL60~84) | LE |
| ⋮ | ⋮ |

BLK1 | PLP Area (1210a)

Normal Area (1210b)

③ Write PLP data to memory cells connected to low energy WL in PLP area

# FIG. 8

# FIG. 9

# FIG. 10

# FIG. 11

# FIG. 12

PL2 — WL16

Stack2

WL9

116
115
114

PL1 — WL8

Stack1

WL1

116
115
114

# FIG. 13

# FIG. 14

Start

Detect Sudden Power-Off ⌒S210

Check size of PLP data ⌒S220

Check size of memory cells having low write energy ⌒S230

Size of PLP data is less than size of memory cells having low write energy ? ⌒S240

Yes

No

Perform PLP write (low energy PLP write) ⌒S250

Write PLP data to memory cells having low write energy ⌒S260

Write remaining PLP data to memory cells having normal write energy ⌒S270

End

# FIG. 15

PLP BLK

| |
|---|
| WL16 |
| WL15 |
| WL14 |
| WL13 |
| WL12 |
| WL11 |
| WL10 |
| WL9 |
| WL8 |
| WL7 |
| WL6 |
| WL5 |
| WL4 |
| WL3 |
| WL2 |
| WL1 |

⑥
⑤
④
③
⑧
②
①
⑦

PLP data

Low energy write

Normal energy write

: LE

: NE

# FIG. 16

```
                    ┌──────────┐
                    │  Start   │
                    └──────────┘
                         │
                         ▼          ╭─S310
        ┌────────────────────────────────┐
        │     Detect Sudden Power-Off     │
        └────────────────────────────────┘
                         │
                         ▼          ╭─S320
        ┌────────────────────────────────┐
        │      Check size of PLP data     │
        └────────────────────────────────┘
                         │
                         ▼          ╭─S330
        ┌────────────────────────────────┐
        │      Check size of memory cells │
        │       having low write energy   │
        └────────────────────────────────┘
                         │
                         ▼          ╭─S340
               ╱◇╲
         ┌──────────────────────────────────┐
         │         Size of PLP data          │
  Yes────│  is less than size of memory cells │
         │       having low write energy ?    │
         └──────────────────────────────────┘
                         │ No
         ╭─S350                          ╭─S360
  ┌──────────────────┐      ┌────────────────────────────┐
  │  Perform PLP write│      │  Determine word line(s) to be│
  │ (low energy PLP   │      │ performed normal energy PLP  │
  │      write)       │      │           write              │
  └──────────────────┘      └────────────────────────────┘
                                         │
                                         ▼        ╭─S370
                            ┌────────────────────────────┐
                            │  Write PLP data to memory cells│
                            │ having low write energy and memory│
                            │  cells determined to be performed │
                            │    normal energy PLP write        │
                            └────────────────────────────┘
                                         │
                                         ▼
                                    ┌──────────┐
                                    │   End    │
                                    └──────────┘
```

# FIG. 17

# FIG. 18

Start

Detect Sudden Power-Off — S410

Write PLP data to memory cells which are connected to wordlines from among 1st group — S420

Write PLP data to memory cells which are connected to wordlines from among 2nd group — S430

End

# FIG. 19

PLP BLK

| | |
|---|---|
| WL16 | |
| WL15 | |
| WL14 | ③ |
| WL13 | |
| WL12 | |
| WL11 | ② |
| WL10 | ① |
| WL9 | |
| WL8 | |
| WL7 | |
| WL6 | ② |
| WL5 | |
| WL4 | |
| WL3 | ① |
| WL2 | ① |
| WL1 | |

Low energy write

PLP data

: LE1

: LE2

: LE3

: NE

# FIG. 20

```
                        ┌─────────┐
                        │  Start  │
                        └─────────┘
                             │
                             ▼
   ┌──────────────────────────────────────────┐
   │         Detect Sudden Power-Off            │────S510
   └──────────────────────────────────────────┘
                             │
                             ▼
   ┌──────────────────────────────────────────┐
   │  Write PLP data to 1st memory cell(s)      │
   │  which is connected to 1st wordline and    │────S520
   │  have 1st write energy                     │
   └──────────────────────────────────────────┘
                             │
                             ▼
   ┌──────────────────────────────────────────┐
   │  Write dummy data to 2nd memory cell(s)    │
   │  which is connected to 2nd word line(s)    │────S530
   └──────────────────────────────────────────┘
                             │
                             ▼
   ┌──────────────────────────────────────────┐
   │  Write PLP data to 3rd memory cell(s) which│
   │  is connected to 3rd wordline and have     │────S540
   │  2nd write energy                          │
   └──────────────────────────────────────────┘
                             │
                             ▼
                        ┌─────────┐
                        │   End   │
                        └─────────┘
```

# FIG. 21

PLP BLK

| WL16 |
| WL15 |
| WL14 |
| WL13 |
| WL12 |
| WL11 |
| WL10 |
| WL9 |
| WL8 |
| WL7 |
| WL6 |
| WL5 |
| WL4 |
| WL3 |
| WL2 |
| WL1 |

Low energy write

PLP data

Dummy write

Dummy data

: LE

: NE

# FIG. 22

PLP BLK

| WL16 |
| WL15 |
| WL14 |
| WL13 |
| WL12 |
| WL11 |
| WL10 |
| WL9 |
| WL8 |
| WL7 |
| WL6 |
| WL5 |
| WL4 |
| WL3 |
| WL2 |
| WL1 |

PLP data

Low energy
write

Normal energy
write

Dummy
write

Dummy data

: LE

: NE

EP 4 723 114 A1

# FIG. 23

```
                    ┌─────────┐
                    │  Start  │
                    └────┬────┘
                         │
                         ▼
  ┌──────────────────────────────────────────────┐
  │ Receive write command in low energy write mode│──── S610
  └──────────────────────┬───────────────────────┘
                         │
                         ▼
  ┌──────────────────────────────────────────────┐
  │ Write user data to 1st memory cell(s) which   │
  │   is connected to 1st wordline and have       │──── S620
  │            1st write energy                    │
  └──────────────────────┬───────────────────────┘
                         │
                         ▼
  ┌──────────────────────────────────────────────┐
  │ Write user data to 2nd memory cell(s) which   │
  │   is connected to 2nd wordline and have       │──── S630
  │            2nd write energy                    │
  └──────────────────────┬───────────────────────┘
                         │
                         ▼
                    ┌─────────┐
                    │   End   │
                    └─────────┘
```

# FIG. 24

# FIG. 25

FIG. 26

# FIG. 27

# FIG. 28

```
        ┌─────────┐
        │  Start  │
        └─────────┘
             │
             ▼
┌───────────────────────────────────┐
│        Receive write command       │──── S710
└───────────────────────────────────┘
             │
             ▼
┌───────────────────────────────────┐
│  Write user data to 1st memory cell(s) │
│  which is connected to 1st wordline and │──── S720
│         have 1st write energy      │
└───────────────────────────────────┘
             │
             ▼
┌───────────────────────────────────┐
│  Write dummy data to 2nd memory cell(s) │
│  which is connected to 2nd word line(s) │──── S730
└───────────────────────────────────┘
             │
             ▼
┌───────────────────────────────────┐
│ Write user data to 3rd memory cell(s) which │
│   is connected to 3rd wordline and have │──── S740
│          2nd write energy          │
└───────────────────────────────────┘
             │
             ▼
        ┌─────────┐
        │   End   │
        └─────────┘
```

# FIG. 29

Europäisches
Patentamt

European
Patent Office

Office européen
des brevets

# EUROPEAN SEARCH REPORT

**Application Number**

EP 25 17 4483

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/282375 A1 (RYU SEUNG HAN [KR] ET AL) 22 August 2024 (2024-08-22) * [0087], [0097], [0116], [0152]; figures 1,8 * | 1-15 | INV. G11C5/14 G11C11/56 G11C16/22 |
| A | US 2022/115082 A1 (OCK EUN JAE [KR]) 14 April 2022 (2022-04-14) * figure 11 * | 1-15 | ADD. G11C16/04 |
| A | US 2018/261281 A1 (MOSCHIANO VIOLANTE [IT] ET AL) 13 September 2018 (2018-09-13) * figures 8-10 * | 1-15 | |

**TECHNICAL FIELDS SEARCHED (IPC)**

G11C

The present search report has been drawn up for all claims

| Place of search | Date of completion of the search | Examiner |
|---|---|---|
| The Hague | 20 October 2025 | Kearey, Robin |

CATEGORY OF CITED DOCUMENTS

X : particularly relevant if taken alone
Y : particularly relevant if combined with another
　　document of the same category
A : technological background
O : non-written disclosure
P : intermediate document

T : theory or principle underlying the invention
E : earlier patent document, but published on, or
　　after the filing date
D : document cited in the application
L : document cited for other reasons

& : member of the same patent family, corresponding
　　document

EPO FORM 1503 03.82 (P04C01)

EP 4 723 114 A1

## ANNEX TO THE EUROPEAN SEARCH REPORT
## ON EUROPEAN PATENT APPLICATION NO.

EP 25 17 4483

This annex lists the patent family members relating to the patent documents cited in the above-mentioned European search report.
The members are as contained in the European Patent Office EDP file on
The European Patent Office is in no way liable for these particulars which are merely given for the purpose of information.

20-10-2025

| Patent document cited in search report | | | Publication date | Patent family member(s) | | Publication date |
|---|---|---|---|---|---|---|
| US 2024282375 | A1 | | 22-08-2024 | KR 20240129456 A | | 27-08-2024 |
| | | | | US 2024282375 A1 | | 22-08-2024 |
| US 2022115082 | A1 | | 14-04-2022 | CN 114360593 A | | 15-04-2022 |
| | | | | KR 20220048377 A | | 19-04-2022 |
| | | | | US 2022115082 A1 | | 14-04-2022 |
| US 2018261281 | A1 | | 13-09-2018 | US 2018261281 A1 | | 13-09-2018 |
| | | | | US 2019272872 A1 | | 05-09-2019 |
| | | | | US 2022415389 A1 | | 29-12-2022 |
| | | | | US 2025166700 A1 | | 22-05-2025 |

**EP 4 723 114 A1**

REFERENCES CITED IN THE DESCRIPTION

**Patent documents cited in the description**

- KR 1020240136104